# EUROPEAN PATENT APPLICATION

(11) **EP 4 734 699 A1**
(43) Date of publication of application: **29.04.2026**
(21) Application number: 25198389.6
(22) Date of filing: 27.08.2025
(51) Int. Cl.: H10D 30/67, H10D 86/40, H10D 86/60, H10K 59/121, H10K 59/131

(54) **DISPLAY APPARATUS AND DISPLAY PANEL**

(30) Priority: 24.10.2024 KR 20240146687
(71) Applicant: LG Display Co., Ltd., Seoul 150-721 (KR)
(72) Inventor: MOON, Sung Ho, Paju-si, Gyeonggi-do (KR); LEE, Sung Jin, Paju-si, Gyeonggi-do (KR); KIM, Dae Hwan, Paju-si, Gyeonggi-do (KR); MOON, Tae Hyoung, Paju-si, Gyeonggi-do (KR); NOH, Sang Soon, Paju-si, Gyeonggi-do (KR)
(74) Representative: Viering, Jentschura & Partner mbB Patent- und Rechtsanwälte

(57) **Abstract**

A display apparatus and a display panel are discussed. The display apparatus includes a substrate (100), a transistor (TR2) disposed in each of a plurality of subpixels (SP) disposed in an active area (AA) of the substrate (100) and including a channel region (CH), an active layer (ACT) at the channel region (CH), and a gate electrode (G) overlapping the active layer (ACT), an external metal layer (LSb) disposed between the active layer (ACT) and the substrate (100) to overlap the active layer (ACT), and an internal metal layer (LSa) disposed between the active layer (ACT) and the external metal layer (LSb) to overlap the active layer (ACT) and the external metal layer (LSb). The plurality of subpixels (SP) include a first subpixel (SP1) and a second subpixel (SP2) configured to emit lights of different colors.

## Description

### BACKGROUND

### Technical Field

The present disclosure relates to a display apparatus, and more specifically, for example, without limitation, to a display apparatus and a display panel in which reliability of transistors can be enhanced.

### Discussion of the Related Art

In televisions (TVs), monitors, smartphones, tablet personal computers (PCs), and notebook computers, display apparatuses for displaying an image are being used in various modes and types.

Display apparatuses include a display panel, which includes a plurality of light emitting devices for implementing an image and a transistor for controlling an operation of each of the light emitting devices or an operation of a liquid crystal, and intactly display an image which is to be displayed through the plurality of light emitting devices or the liquid crystal.

In some display apparatuses, a plurality of pixels are provided, where each pixel includes a light emitting device. A plurality of driving and switching elements for driving and controlling the light emitting device are included in each of the pixels. The driving and switching elements can each be configured as a transistor.

Recently, various research and developments for enhancing the performance and reliability of transistors are being done.

The description provided in the description of the related art section should not be assumed to be prior art merely because it is mentioned in or associated with the description of the related art section. The description of the related art section can include information that describes one or more aspects of the subject technology, and the description in this section does not limit the disclosure.

### SUMMARY OF THE DISCLOSURE

The inventors have realized that in a related art, there can be a limitation on performance and reliability of transistors. Accordingly, example embodiments of the present disclosure provide a display apparatus in which reliability can be enhanced.

Example embodiments of the present disclosure can differently set a sub-threshold swing (S-factor) and an on current value, based on an emission characteristic of each subpixel.

Example embodiments of the present disclosure can enhance the quality of an image displayed by a display panel.

Example embodiments of the present disclosure can enhance the reliability of transistors and can decrease power consumption, thereby implementing environment, social, and governance (ESG).

To achieve these objects and other advantages and in accordance with the purpose of the disclosure, as embodied and broadly described herein, a display apparatus according to claim 1 is provided. Preferred embodiments of the display apparatus are described in the dependent claims. In an aspect of the present disclosure, a display apparatus includes a substrate, a transistor disposed in each of a plurality of subpixels disposed in an active area of the substrate and including a channel region, an active layer including first and second source-drain regions at both sides of the channel region, and a gate electrode overlapping the active layer, an external metal layer disposed between the active layer and the substrate to overlap the active layer, and an internal metal layer disposed between the active layer and the external metal layer to overlap the active layer and the external metal layer, wherein the plurality of subpixels can include a first subpixel and a second subpixel emitting lights of different colors, and a width of a non-overlap region, which does not overlap the internal metal layer, of a region of the external metal layer overlapping the active layer in the first subpixel can differ from a width of a non-overlap region, which does not overlap the internal metal layer, of a region of the external metal layer overlapping the active layer in the second subpixel.

According to aspects of the present disclosure, in each of the first and second subpixels, the entire channel region can overlap the external metal layer, a width of the internal metal layer is less than a width of the external metal layer, and one end of the internal metal layer disposed at an opposite side of the non-overlap region of the external metal layer can be disposed at a portion overlapping one of the first and second source-drain regions.

According to aspects of the present disclosure, the transistor can supply a driving current to a light emitting device of each of the plurality of subpixels.

According to a first example embodiment of the present disclosure, in each of the first and second subpixels, the external metal layer can be electrically connected to one of the gate electrode and one of the first and second source-drain regions, and the internal metal layer can be electrically connected to the other of the gate electrode and one of the first and second source-drain regions.

According to aspects of the present disclosure, in each of the first and second subpixels, the external metal layer can be electrically connected to the gate electrode, and the internal metal layer can be electrically connected to one of the first and second source-drain regions.

According to aspects of the present disclosure, in each of the first and second subpixels, the external metal layer can be electrically connected to one of the first and second source-drain regions, and the internal metal layer can be electrically connected to the gate electrode.

According to aspects of the present disclosure, in each of the first and second subpixels, the internal metal layer can be electrically connected to one of the first and second source-drain regions, and the external metal layer can be electrically connected to the gate electrode, the first subpixel emits green light, and the second subpixel can emit blue light, and a first width of the non-overlap region of the external metal layer in the first subpixel can be less than a second width of the non-overlap region of the external metal layer in the second subpixel.

According to aspects of the present disclosure, an end of one side of the internal metal layer in the first subpixel can overlap the first source-drain region, and an end of the other side of the internal metal layer adjacent to the non-overlap region of the external metal layer can overlap the second source-drain region, and an end of one side of the internal metal layer in the second subpixel can overlap the first source-drain region, and an end of the other side of the internal metal layer adjacent to the non-overlap region of the external metal layer can overlap the channel region.

According to aspects of the present disclosure, the plurality of subpixels can further include a third subpixel emitting light of a color which differs from the first and second subpixels, and a third width of a non-overlap region, which does not overlap the internal metal layer, of a region of the external metal layer overlapping the active layer in the third subpixel can differ from the first width and the second width.

According to aspects of the present disclosure, the third subpixel can emit red light, and the third width of the non-overlap region of the external metal layer in the third subpixel can be greater than the first width and less than the second width.

According to a second example embodiment of the present disclosure, in each of the first and second subpixels, the internal metal layer can be electrically connected to the gate electrode, and the external metal layer can be electrically connected to one of the first and second source-drain regions, the first subpixel can emit green light, and the second subpixel emits blue light, and a fourth width of the non-overlap region of the external metal layer in the first subpixel can be greater than a fifth width of the non-overlap region of the external metal layer in the second subpixel.

According to aspects of the present disclosure, an end of one side of the internal metal layer in the first subpixel can overlap the first source-drain region, and an end of the other side of the internal metal layer adjacent to the non-overlap region of the external metal layer can overlap the channel region, and an end of one side of the internal metal layer in the second subpixel can overlap the first source-drain region, and an end of the other side of the internal metal layer adj acent to the non-overlap region of the external metal layer can overlap the second source-drain region.

According to aspects of the present disclosure, the plurality of subpixels can further include a third subpixel emitting light of a color which differs from the first and second subpixels, and a sixth width of the non-overlap region of the external metal layer in the third subpixel can differ from the fourth width and the fifth width.

According to aspects of the present disclosure, the third subpixel can emit red light, and the sixth width of the non-overlap region of the external metal layer in the third subpixel can be greater than the fifth width and less than the fourth width.

According to aspects of the present disclosure, the active layer can include an oxide semiconductor material.

In another aspect of the present disclosure, a display apparatus includes a substrate, a transistor disposed in each of a plurality of subpixels disposed in an active area of the substrate and including a channel region, a first active layer including first and second source-drain regions at both sides of the channel region, and a first gate electrode overlapping the first active layer, an external metal layer disposed between the first active layer and the substrate to overlap the first active layer, and an internal metal layer disposed between the first active layer and the external metal layer to overlap the first active layer and the external metal layer, wherein the plurality of subpixels include a first subpixel and a second subpixel emitting lights of different colors, a width of a non-overlap region, which does not overlap the internal metal layer, of a region of the external metal layer overlapping the first active layer in the first subpixel differs from a width of a non-overlap region, which does not overlap the internal metal layer, of a region of the external metal layer overlapping the first active layer in the second subpixel, and the display apparatus further includes a switching transistor disposed in each of a plurality of subpixels disposed in the active area of the substrate and including a second active layer, a second gate electrode overlapping the second active layer, and a lower metal layer disposed on the same layer as one of the internal metal layer and the external metal layer.

According to aspects of the present disclosure, the lower metal layer can be connected to the second gate electrode via a gate connection electrode.

According to aspects of the present disclosure, a thickness of the lower metal layer can be same as that of one of the internal metal layer and the external metal layer.

According to the first example embodiment, in each of the first and second subpixels, the internal metal layer can be electrically connected to one of the first and second source-drain regions, and the external metal layer can be electrically connected to the gate electrode, the first subpixel emits green light, and the second subpixel emits blue light, and a first width of the non-overlap region of the external metal layer in the first subpixel can be less than a second width of the non-overlap region of the external metal layer in the second subpixel.

According to aspects of the present disclosure, the plurality of subpixels can further include a third subpixel emitting light of a color which differs from the first and second subpixels, and a third width of a non-overlap region, which does not overlap the internal metal layer, of a region of the external metal layer overlapping the first active layer in the third subpixel can differ from the first width and the second width.

According to aspects of the present disclosure, the third subpixel can emit red light, and the third width of the non-overlap region of the external metal layer in the third subpixel can be greater than the first width and less than the second width.

According to the second example embodiment, in each of the first and second subpixels, the internal metal layer can be electrically connected to the gate electrode, and the external metal layer can be electrically connected to one of the first and second source-drain regions, the first subpixel emits green light, and the second subpixel can emit blue light, and a fourth width of the non-overlap region of the external metal layer in the first subpixel can be greater than a fifth width of the non-overlap region of the external metal layer in the second subpixel.

According to aspects of the present disclosure, the plurality of subpixels can further include a third subpixel emitting light of a color which differs from the first and second subpixels, and a sixth width of the non-overlap region of the external metal layer in the third subpixel can differ from the fourth width and the fifth width.

According to aspects of the present disclosure, the third subpixel can emit red light, and the sixth width of the non-overlap region of the external metal layer in the third subpixel can be greater than the fifth width and less than the fourth width.

As embodied and broadly described herein, according to aspects of the present disclosure, a display panel includes a substrate, a transistor disposed in each of a plurality of subpixels disposed in an active area of the substrate and including a channel region, an active layer including first and second source-drain regions at both sides of the channel region, and a gate electrode overlapping the active layer, an external metal layer disposed between the active layer and the substrate to overlap the active layer, and an internal metal layer disposed between the active layer and the external metal layer to overlap the active layer and the external metal layer, wherein the plurality of subpixels can include a first subpixel and a second subpixel emitting lights of different colors, and a width of a non-overlap region, which does not overlap the internal metal layer, of a region of the external metal layer overlapping the active layer in the first subpixel can differ from a width of a non-overlap region, which does not overlap the internal metal layer, of a region of the external metal layer overlapping the active layer in the second subpixel.

In another aspect of the present disclosure, a display panel includes a substrate, a transistor disposed in each of a plurality of subpixels disposed in an active area of the substrate and including a channel region, a first active layer including first and second source-drain regions at both sides of the channel region, and a first gate electrode overlapping the first active layer, an external metal layer disposed between the first active layer and the substrate to overlap the first active layer, and an internal metal layer disposed between the first active layer and the external metal layer to overlap the first active layer and the external metal layer, wherein the plurality of subpixels include a first subpixel and a second subpixel emitting lights of different colors, a width of a non-overlap region, which does not overlap the internal metal layer, of a region of the external metal layer overlapping the first active layer in the first subpixel differs from a width of a non-overlap region, which does not overlap the internal metal layer, of a region of the external metal layer overlapping the first active layer in the second subpixel, and the display apparatus further includes a switching transistor disposed in each of a plurality of subpixels disposed in the active area of the substrate and including a second active layer, a second gate electrode overlapping the second active layer, and a lower metal layer disposed on the same layer as one of the internal metal layer and the external metal layer.

In another aspect of the present disclosure, a display panel includes a substrate, a driving transistor disposed in each of a plurality of subpixels disposed in an active area of the substrate and including a channel region, a first active layer including first and second source-drain regions at both sides of the channel region, and a first gate electrode overlapping the first active layer, an external metal layer disposed between the first active layer and the substrate to overlap the first active layer, an internal metal layer disposed between the first active layer and the external metal layer to overlap the first active layer and the external metal layer, and a switching transistor disposed in each of a plurality of subpixels disposed in the active area of the substrate and including a second active layer, a second gate electrode overlapping the second active layer, and a lower metal layer disposed on the same layer as one of the internal metal layer and the external metal layer.

Objects of example embodiments of the present disclosure are not limited to the above-described objects, and other objects that are not mentioned will be able to be clearly understood by those skilled in the art from the following description.

### BRIEF DESCRIPTION OF THE DRAWINGS

The accompanying drawings, which are included to provide a further understanding of the disclosure and are incorporated in and constitute a part of this application, illustrate example embodiment(s) of the disclosure and together with the description serve to explain the principle of the disclosure. In the drawings:
FIG. 1 is a diagram for describing an example embodiment of a display apparatus applicable to the present disclosure;
FIG. 2, including views (a) and (b), illustrates diagrams for describing an example embodiment of a circuit diagram of a subpixel applicable to a display apparatus according to the present disclosure;
FIG. 3 is a diagram for describing an example embodiment of a transistor included in a first subpixel in a display apparatus according to the present disclosure;
FIG. 4 is a diagram for describing an example embodiment of a transistor included in a second subpixel in a display apparatus according to the present disclosure;
FIG. 5 is a diagram for describing an example embodiment of a transistor included in a third subpixel in a display apparatus according to the present disclosure;
FIG. 6, including views (a) and (b), illustrates diagrams for describing an electrical characteristic curve based on a transistor included in each of first and second subpixels described with reference to FIGS. 3 and 4;
FIG. 7 is a diagram for describing an example embodiment where the transistor of the first subpixel illustrated in FIG. 3 is applied to a display apparatus;
FIG. 8 is a diagram for describing another example embodiment of a transistor included in a first subpixel in a display apparatus according to the present disclosure;
FIG. 9 is a diagram for describing another example embodiment of a transistor included in a second subpixel in a display apparatus according to the present disclosure; and
FIG. 10 is a diagram for describing another example embodiment of a transistor included in a third subpixel in a display apparatus according to the present disclosure.

Throughout the drawings and the detailed description, unless otherwise described, the same drawing reference numerals should be understood to refer to the same elements, features, and structures. The relative size and depiction of these elements can be exaggerated for clarity, illustration, and convenience.

### DETAILED DESCRIPTION OF THE DISCLOSURE

Reference will now be made in detail to embodiments of the present disclosure, examples of which can be illustrated in the accompanying drawings. The progression of processing steps and/or operations described is an example; however, the sequence of steps and/or operations is not limited to that set forth herein and can be changed as is known in the art, with the exception of steps and/or operations necessarily occurring in a particular order. Names of the respective elements used in the following explanations can be selected only for convenience of writing the disclosure and can be thus different from those used in actual products.

The advantages and features of the present disclosure, and methods of achieving them will become apparent upon reference to the embodiments described in detail below in conjunction with the accompanying drawings. However, the present disclosure is not limited to the following embodiments disclosed herein, but can be implemented in various different forms; rather, the present embodiments are provided to make the disclosure of the present disclosure complete and to enable those skilled in the art to fully comprehend the scope of the present disclosure.

The shapes, sizes, dimensions (e.g., length, width, height, thickness, radius, diameter, area, etc.), ratios, angles, numbers, and the like of elements shown in the drawings to illustrate embodiments of the present disclosure are merely illustrative and are not intended to be limiting. Identical reference numerals can designate identical components throughout the description. Further, in describing the present disclosure, detailed descriptions of related known technologies can be omitted so as not to obscure the essence of the present disclosure.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals refer to like elements. Further, a thickness, a ratio, and a dimension of each element described herein are illustrated to be partially enlarged or reduced for convenience of effective description. A scale of each element illustrated in the drawings of the present disclosure can have a scale which differs from a real scale, for convenience of description, but is not limited to a scale illustrated in the drawings.

In the present disclosure, when an arbitrary element (or a region, a layer, a portion, etc.) is described as "on", "above", "over", "below", "under", "beside", "beneath", "near", "close to," "adjacent to", "on a side of", "next", "connected", or "coupled", this can denote that the arbitrary element can be directly connected/coupled to another element, or a third element can be disposed therebetween.

The term "and/or" can include all of one or more combinations capable of being defined by relevant elements.

Terms like a first and a second can be used to describe various elements, but the elements should not be limited by the terms. The terms can be used only as object for distinguishing an element from another element. For example, without departing from the spirit and scope of the inventive concept, a first element can be referred to as a second element, and similarly, the second element can be referred to as the first element. The terms of a singular form can include plural forms unless referred to the contrary.

The terms "under", "below", "on", and "above" can be used to describe a correlation between elements illustrated in the drawings. The terms can be a relative concept and can be described with respect to a direction illustrated in the drawings. For example, unless "just" or "direct" is used, one or more other elements between two elements can be disposed. Spatially relative terms "below", "beneath", "lower", "above", and "upper" can be used herein for easily describing a relationship between one device or elements and other devices or elements as illustrated in the drawings. Therefore, for example, "under" and "lower" can be opposite to "on" and "upper" with respect to a first element.

It should be understood that spatially relative terms are terms including different orientations of elements in use or operation, in addition to the orientation illustrated in the drawings. For example, if a device in the drawings is turned over, elements described as being on the "below" or "beneath" sides of other elements can be placed on "above" sides of the other elements. Therefore, the example term "lower" can include both orientations of "lower" and "upper". Likewise, the example term "above" or "upper" can include both orientations of above and below.

It should be understood that the meaning of "include," "have," "comprise," "contain," "constitute," "make up of," "formed of," and "consist of" specifies a property, a region, a fixed number, a step, a process, an element and/or a component, but does not exclude other properties, regions, fixed numbers, steps, processes, elements and/or components. Further, the term "can" fully encompasses all the meanings and coverages of the term "may" and vice versa.

A term "apparatus" used herein can refer to a display apparatus including a display panel and a driver for driving the display panel. Examples of the display apparatus can include a light emitting element, and the like. In addition, examples of the apparatus can include a notebook computer, a television, a computer monitor, an automotive device, a wearable device, and an automotive equipment device, and a set electronic device (or apparatus) or a set device (or apparatus), for example, a mobile electronic device such as a smartphone or an electronic pad, which are complete products or final products respectively including light emitting element and the like, but embodiments of the present disclosure are not limited thereto.

Features of various example embodiments of the present disclosure can be partially or overall coupled to or combined with each other and can be variously inter-operated with each other and driven technically as those skilled in the art can sufficiently understand. The example embodiments of the present disclosure can be carried out independently from each other, or can be carried out together in co-dependent relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein.

In the aspects of the present disclosure, a source electrode and a drain electrode are distinguished from each other, for convenience of description. However, the source electrode and the drain electrode are used interchangeably. The source electrode can be the drain electrode, and the drain electrode can be the source electrode. Further, the source electrode in any one aspect of the present disclosure can be the drain electrode in another aspect of the present disclosure, and the drain electrode in any one aspect of the present disclosure can be the source electrode in another aspect of the present disclosure.

Hereinafter, a display apparatus according to example embodiments of the present disclosure will be described with reference to the accompanying drawings. All the components of each display apparatus/device according to all embodiments of the present disclosure are operatively coupled and configured.

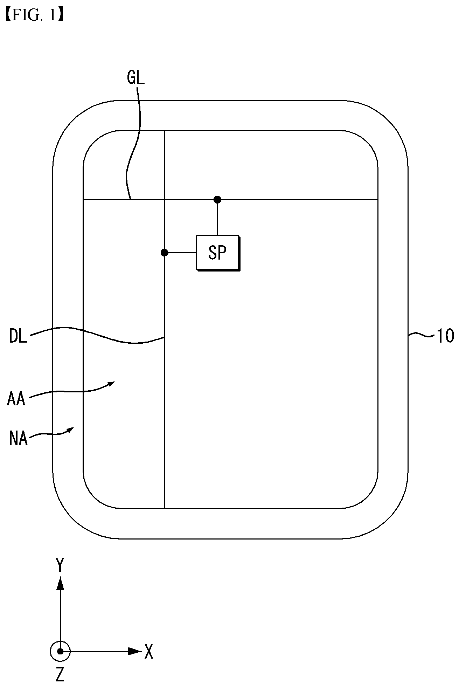

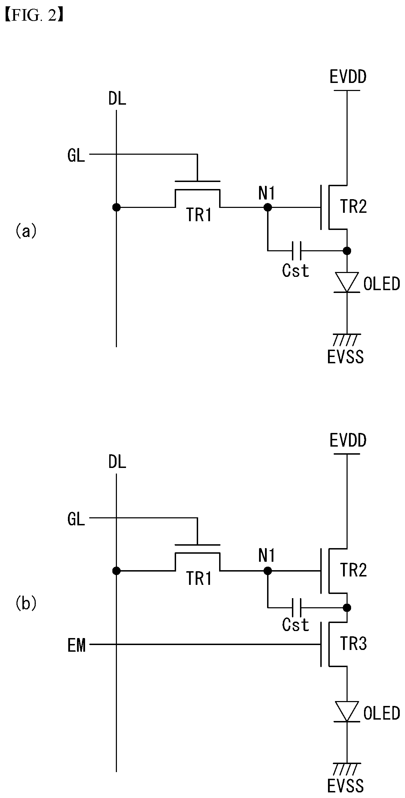

FIG. 1 is a diagram for describing an example embodiment of a display apparatus applicable to the present disclosure, and FIG. 2 is a diagram for describing an example embodiment of a circuit diagram of a subpixel SP applicable to a display apparatus according to the present disclosure.

Referring to FIGS. 1 and 2, the display apparatus according to an example embodiment of the present disclosure can include a display panel 10, and the display panel 10 can include an active area AA and a non-active area NA.

The display panel 10 can have a width in a Y-axis direction, a length in a X-axis direction, and a thickness in a Z-axis direction, but not limited thereto. For example, the display panel 10 can have a width in an X-axis direction, a length in a Y-axis direction, and a thickness in a Z-axis direction. The X-axis direction and the Y-axis direction can intersect each other on the plane of the display panel 10. For example, the X-axis direction and the Y-axis direction can be orthogonal to each other, but not limited thereto.

The active area AA can be an area which displays an image. A plurality of subpixels SP can be disposed in the active area AA of the display panel 10, and the active area AA can display an image by using the plurality of subpixels SP. An area where the plurality of subpixels SP are disposed can be the active area AA, and an area other than the active area AA can be the non-active area NA. The non-active area NA can be placed outside the active area AA. For example, the non-active area NA can be an area adjacent to the display region DA. Further, the non-active area NA can be an area disposed adjacent to the active area AA and configured to surround the display region DA entirely or only in part(s).

The non-active area NA can be disposed in an edge region surrounding the active area AA which displays an image. At least one driver for driving the plurality of subpixels SP can be disposed in the non-active area NA. The driver can be a gate in panel (GIP) type.

Various additional elements for driving the subpixels SP of the active area AA can be further disposed in the non-active area NA.

At least one subpixel SP among a plurality of pixels or subpixels, for example, as illustrated in (a) or (b) of FIG. 2, can include a first transistor TR1, a second transistor TR2, a capacitor Cst, and a light emitting device OLED.

For example, the first transistor TR1 can be a switching transistor, and the second transistor TR2 can be a driving transistor.

A first electrode (for example, a drain electrode) of the first transistor TR1 can be electrically connected to a data line DL, a second electrode (for example, a source electrode) thereof can be electrically connected to a first node N1, and a gate electrode of the first transistor TR1 can be electrically connected to a gate line GL. The first transistor TR1 can transfer a data signal, supplied through the data line DL, to the first node N1 in response to a scan signal supplied through the gate line GL.

The capacitor Cst can be electrically connected to the first node N1 and can be charged with a voltage applied to the first node N1.

A first electrode (for example, a drain electrode) of the second transistor TR2 can be supplied with a high-level driving voltage EVDD, and a second electrode (for example, a source electrode) thereof can be electrically connected to a first electrode of the light emitting device OLED. The second transistor TR2 can control the amount of driving current flowing in the light emitting device OLED, based on a voltage applied to a gate electrode thereof.

An active layer of the first transistor TR1 and/or the second transistor TR2 can include semiconductor oxide such as indium-gallium-zinc-oxide (IGZO), but is not limited thereto.

The light emitting device OLED can emit light corresponding to a driving current. The light emitting device OLED can emit light corresponding to one color of red, green, blue, and white.

The light emitting device OLED can include the anode electrode, an emission layer disposed on the anode electrode, and a cathode electrode supplying a common voltage. The emission layer can be implemented to emit light of the same color for each pixel, like white light, or can be implemented to emit lights of different colors for each subpixel SP, like red (R) light, green (G) light, or blue (B) light.

The light emitting device OLED can be a diode of a top emission type, or can be a diode of a bottom emission type.

In (a) of FIG. 2, a case where the second transistor TR2 corresponding to a driving transistor is directly connected to the light emitting device OLED is illustrated for example, but the present disclosure is not limited thereto and as illustrated in (b) of FIG. 2, the second transistor TR2 can be connected to the light emitting device OLED through a third transistor TR3 which is a switching transistor.

In detail, as in (b) of FIG. 2, the third transistor TR3 can be disposed between the second transistor TR2 and the light emitting device OLED, a first electrode of the third transistor TR3 can be connected to the second electrode of the second transistor TR2, and a second electrode of the third transistor TR3 can be electrically connected to the first electrode of the light emitting device OLED. In response to an emission signal applied to the gate electrode of the second transistor TR2, the third transistor TR3 can control the on/off of the driving current applied from the second transistor TR2 to the light emitting device OLED.

Moreover, although not shown in (a) of FIG. 2 and (b), a compensation circuit for compensating for a threshold voltage of the second transistor TR2 corresponding to the driving transistor can be further included in the subpixel SP. The compensation circuit can include at least one transistor connected to the second transistor TR2 and can be provided in the subpixel SP.

Based on a configuration type, the compensation circuit can have a 3T1C structure where three transistors and one capacitor Cst are included in the subpixel SP, or a 4T2C structure where four transistors and two capacitors Cst are included in the subpixel SP, or various structures such as 5T2C, 6T1C, 6T2C, 7T1C, and 7T2C.

In (a) and (b) of FIG. 2, each transistor can include an active layer including a semiconductor material and a gate electrode which controls the turn-on/off of a channel included in the active layer.

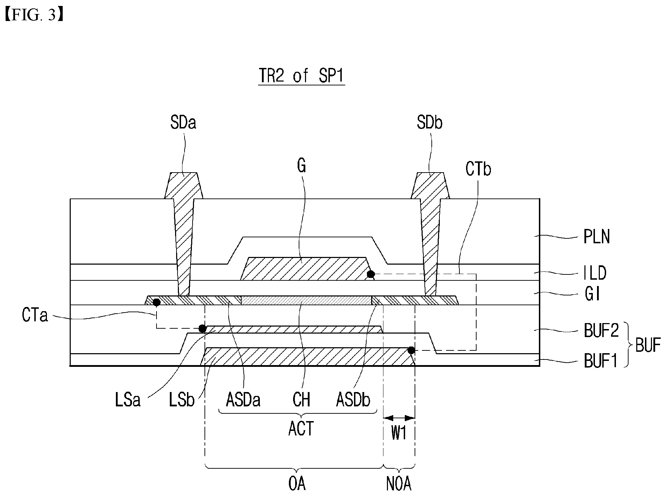

In the present disclosure, the second transistor TR2 which is a driving transistor can include a plurality of metal layers overlapping the active layer, so as to minimize an adverse effect of external light on the active layer and enhance a sub-threshold swing (S-factor) or an on current value of the driving transistor included in each subpixel SP. As described above, each of the plurality of metal layers can be electrically connected to one of first and second source-drain regions of the active layer, for a stable operation environment of a transistor, or can be electrically connected to the gate electrode so as to enhance a turn-on characteristic of a transistor. This will be described below in detail with reference to FIG. 3.

Moreover, in the display apparatus of the present disclosure described above with reference to FIGS. 1 and 2, in the plurality of subpixels included in the active area AA, a first subpixel SP1 emitting green (G), a second subpixel SP2 emitting blue (B), and a third subpixel SP3 emitting red (R) can configure one unit pixel, and in addition to the first subpixel SP1, the second subpixel SP2, and the third subpixel SP3, a subpixel SP emitting white light can configure one unit pixel.

For example, the plurality of subpixels can include red, green, and blue subpixels, in which the red, green, and blue subpixels can be disposed in a repeated manner. Alternatively, the plurality of subpixels can include red, green, blue, and white subpixels, in which the red, green, blue, and white subpixels can be disposed in a repeated manner, or the red, green, blue, and white subpixels can be disposed in a quad type. For example, the red sub pixel, the blue sub pixel, and the green sub pixel can be sequentially disposed along a row direction, or the red sub pixel, the blue sub pixel, the green sub pixel and the white sub pixel can be sequentially disposed along the row direction. However, in the embodiment of the present disclosure, the color type, disposition type, and disposition order of the subpixels are not limiting, and can be configured in various forms according to light-emitting characteristics, device lifespans, and device disclosures.

Meanwhile, the subpixels can have different light-emitting areas according to light-emitting characteristics. For example, a subpixel that emits light of a color different from that of a blue subpixel can have a different light-emitting area from that of the blue subpixel. For example, the red subpixel, the blue subpixel, and the green subpixel, or the red subpixel, the blue subpixel, the white subpixel, and the green subpixel can each has a different light-emitting area.

Each unit pixel can adjust the luminance of light emitted from each of the first subpixel SP1, the second subpixel SP2, and the third subpixel SP3 to implement desired color coordinates, and moreover, can summate light emitted from each subpixel to implement a desired sense of color.

Color coordinates or a sense of color of each subpixel SP described above can vary based on an S-factor or an on current value of a transistor which supplies a driving current to a light emitting device in each subpixel.

The S-factor can be calculated as an inverse number value of a slope of a transition section where an off status is changed to an on status in an electrical characteristic curve of a driving transistor which generates the driving current and supplies the driving current to the light emitting device OLED.

The S-factor, for example, can be used as an indicator representing the degree of variation of a drain-source current Ids with respect to a gate-source voltage Vgs in a transition section of the driving transistor. Here, the gate-source voltage Vgs can be a voltage difference between a gate electrode and a source electrode of the driving transistor, and the drain-source current Ids can be a driving current which is supplied to the light emitting device OLED.

When the S-factor increases, this can denote that a drain-source current Ids variation rate with respect to a gate voltage in the transition section decreases, and when the S-factor decreases, this can denote that a drain-source current Ids variation rate with respect to the gate voltage in the transition section increases.

Therefore, when the S-factor is large, a drain-source current Ids variation rate with respect to a gate voltage can be small, and thus, a drain-source current Ids variation with respect to a variation of a gate voltage can gently progress, whereby grayscale expression can be more stably and finely controlled. On the other hand, when the S-factor is small, a drain-source current Ids variation rate with respect to a gate voltage can be large, and thus, a drain-source current Ids variation with respect to a variation of a gate voltage can rapidly progress, whereby grayscale expression can be relatively unstable.

Moreover, when an on current value of a transistor increases, a concentration of carriers moving when the transistor is turned on can relatively increase, and thus, the driving current can relatively more increase, whereby the luminance of light emitted from a corresponding pixel can more increase.

The display apparatus according to the present disclosure can appropriately adjust an S-factor or an on current value of a driving transistor included in each subpixel SP to enhance color coordinates or a sense of color. To this end, in the display apparatus according to the present disclosure, a width of a non-overlap region between a plurality of metal layers connected to the second transistor TR2 which is a driving transistor supplying a driving current to an emission layer can be differently configured for each subpixel SP.

Hereinafter, a width of a non-overlap region between a plurality of metal layers differently applied for each subpixel SP will be described with reference to FIGS. 3 to 6.

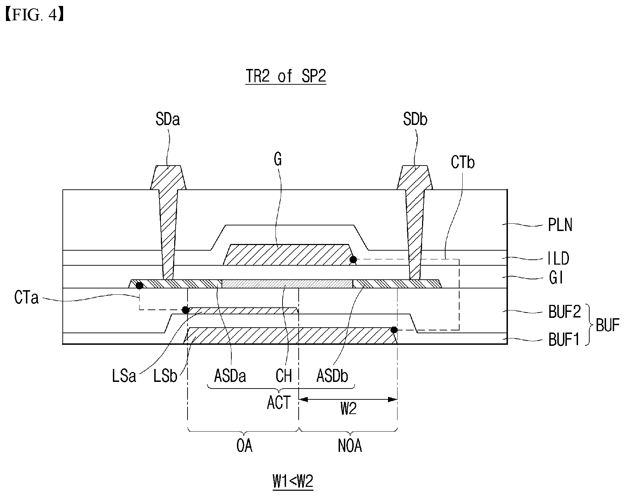

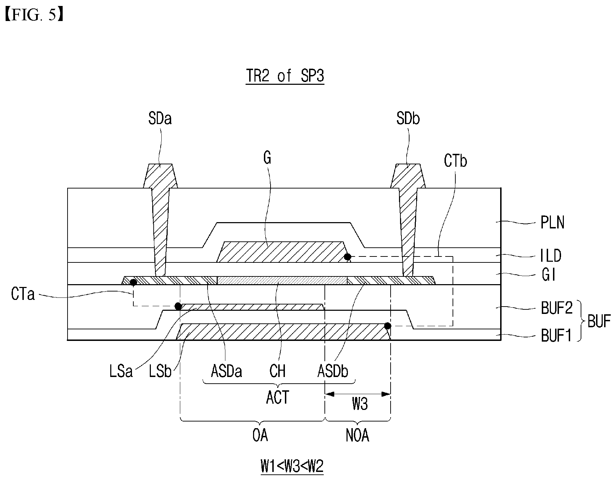

FIG. 3 is a diagram for describing an example embodiment of a transistor included in a first subpixel SP1 in a display apparatus according to the present disclosure, FIG. 4 is a diagram for describing an example embodiment of a transistor included in a second subpixel SP2 in a display apparatus according to the present disclosure, and FIG. 5 is a diagram for describing an example embodiment of a transistor included in a third subpixel SP3 in a display apparatus according to the present disclosure.

Referring to FIGS. 3 to 5, in the present disclosure, each of first to third subpixels SP1 to SP3 included in one unit pixel can include a plurality of metal layers LSa and LSb overlapping an active layer ACT of a transistor.

The first to third subpixels SP1 to SP3 can be subpixels emitting different lights. For example, the first subpixel SP1 of FIG. 3 can be a subpixel emitting green (G) light, the second subpixel SP2 of FIG. 4 can be a subpixel emitting blue (B) light, the third subpixel SP3 of FIG. 5 can be a subpixel emitting red (R) light, and a transistor illustrated in each of FIGS. 3 to 5 can be a driving transistor TR2 included in each of the first to third subpixels SP1 to SP3.

Each of driving transistors illustrated in FIGS. 3 to 5 can be the second transistor TR2 illustrated in FIG. 2, and for example, a driving current for driving a light emitting device which is included in each of the first to third subpixels SP1 to SP3 and emits green (G), blue (B), or red (R) light can be generated.

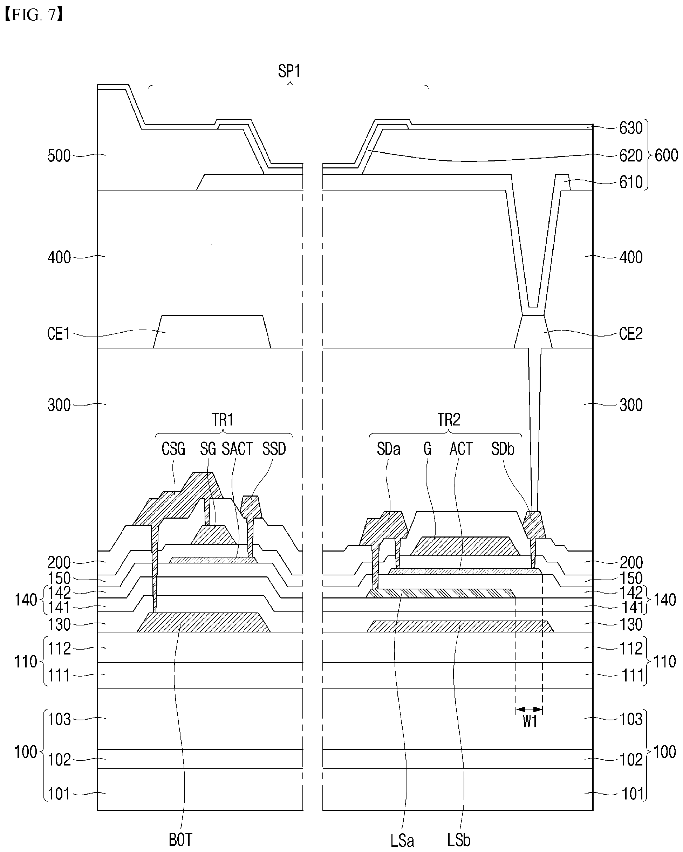

The substrate can be disposed under a transistor as in FIG. 7 described below for example.

As illustrated in FIGS. 3 to 5, each of the first to third subpixels SP1 to SP3 can include a driving transistor TR2 including an active layer ACT, a gate electrode G, and first and second source-drain electrodes SDa and SDb, an external metal layer LSb, and an internal metal layer LSa.

The active layer ACT can include a channel region CH and first and second source-drain regions ASDa and ASDb provided at both sides of the channel region CH.

The active layer ACT can include an oxide semiconductor material. The oxide semiconductor material included in the active layer ACT can include, for example, at least one of InZnO (IZO)-based, InGaO (IGO)-based, InSnO (ITO)-based, InGaZnO (IGZO)-based, InGaZnSnO (IGZTO)-based, GaZnSnO (GZTO)-based, GaZnO (GZO)-based, InSnZnO (ITZO)-based, and FeInZnO (FIZO)-based oxide semiconductor materials, but the present disclosure is not limited thereto.

The channel region CH can be disposed in a portion overlapping the gate electrode G, and the first and second source-drain regions ASDa and ASDb can be disposed at both outer sides of the channel region CH. The first and second source-drain regions ASDa and ASDb can include a first source-drain region ASDa disposed at one side of the channel region CH and a second source-drain region ASDb disposed at the other side of the channel region CH.

The channel region CH can have a doping concentration of dopants which are relatively lower than the first and second source-drain regions ASDa and ASDb and can have an electrical conductivity corresponding to a voltage applied to the gate electrode G, and a channel where a carrier moves based on the voltage applied to the gate electrode G can be formed therein. Depending on the case, the channel region CH can maintain an intrinsic feature of an oxide semiconductor material without doping of a dopant.

The first and second source-drain regions ASDa and ASDb can be higher in concentration of doped dopants than the channel region CH and can be a conductive region which is high in electrical conductivity.

The gate electrode G can be disposed apart from the active layer ACT to overlap the active layer ACT. The gate electrode G can control an operation of forming a channel in the channel region CH of the active layer ACT, based on a voltage applied thereto.

The gate electrode G can include a conductive material, and for example, can include metal such as aluminum (Al), chrome (Cr), copper (Cu), titanium (Ti), molybdenum (Mo), and tungsten (W), but not limited thereto.

A gate insulation layer GI can be disposed between the gate electrode G and the active layer ACT to insulate the gate electrode G from the active layer ACT. The gate insulation layer GI can include at least one of silicon oxide (SiOx), silicon nitride (SiNx), and silicon oxynitride (SiOxNy). For example, the silicon oxide (SiOx) can include silicon dioxide (SiO₂). For example, the gate insulation layer GI can be configured as a single layer or multi-layer of silicon oxide (SiOx), silicon nitride (SiNx), or silicon oxynitride (SiOxNy), for example, the gate insulation layer GI can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

An interlayer insulation layer ILD covering the gate insulation layer GI can be disposed on the gate insulation layer GI. The interlayer insulation layer ILD can extend along the gate insulation layer GI. The interlayer insulation layer ILD can include an insulating material such as SiOx, SiNx or SiOxNy. For example, the interlayer insulation layer ILD can be configured as a single layer or multi-layer of silicon oxide (SiOx), silicon nitride (SiNx), or silicon oxynitride (SiOxNy), for example, the interlayer insulation layer ILD can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

A planarization layer PNL including an insulating material can be disposed on the interlayer insulation layer ILD. The planarization layer PNL can remove a step height caused by a transistor in a subpixel SP. An upper surface of the planarization layer PNL can include a flat surface and can include a material having high flowability. For example, the planarization layer PNL can include an organic insulating material. For example, the planarization layer PNL can be formed of an organic layer such as an acryl-based material, an epoxy-based material, a phenolic-based material, a polyamide-based material, or a polyimide-based material, but example embodiments of the present disclosure are not limited thereto.

The first source-drain electrode SDa and the second source-drain electrode SDb can be disposed on the planarization layer PNL and can be electrically and respectively connected to the first source-drain electrode SDa and the second source-drain electrode SDb. The first source-drain electrode SDa can contact the first source-drain region ASDa, and the second source-drain electrode SDb can contact the second source-drain region ASDb.

As illustrated in FIGS. 3 to 5, a case where the first and second source-drain electrodes SDa and SDb pass through the planarization layer PNL, the interlayer insulation layer ILD, and the gate insulation layer GI and are electrically connected to the first and second source-drain regions ASDa and ASDb is illustrated for example.

However, the present disclosure is not limited thereto, and the first and second source-drain electrodes SDa and SDb can be disposed on the interlayer insulation layer ILD, can pass through the interlayer insulation layer ILD and the gate insulation layer GI, and can electrically contact the first and second source-drain regions ASDa and ASDb. The first and second source-drain electrodes SDa and SDb can be electrically insulated from the gate electrode G by the interlayer insulation layer ILD and the gate insulation layer GI.

The internal metal layer LSa and the external metal layer LSb can be provided apart from each other under the active layer ACT, and a buffer layer BUF can be disposed between the active layer ACT, the internal metal layer LSa, and the external metal layer LSb. The buffer layer BUF can include an insulating material such as SiOx, SiNx or SiOxNy and can be provided in a multi-layer structure including first and second buffer layers BUF1 and BUF2. For example, each of the first and second buffer layers BUF1 and BUF2 can be configured as a single layer or multi-layer of silicon oxide (SiOx), silicon nitride (SiNx), or silicon oxynitride (SiOxNy), for example, each of the first and second buffer layers BUF1 and BUF2 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto. The first buffer layer BUF1 can be disposed between the internal metal layer LSa and the external metal layer LSb, and the second buffer layer BUF2 can be disposed between the internal metal layer LSa and the active layer ACT.

A substrate (for example, 100 of FIG. 7) can be disposed between the external metal layer LSb and the active layer ACT. For example, as illustrated in FIGS. 3 to 5, the external metal layer LSb can be disposed apart from the active layer ACT and can be disposed under the buffer layer BUF adjacent to the substrate. The external metal layer LSb and the active layer ACT can be spaced apart from and insulated from each other by the buffer layer BUF.

The external metal layer LSb can include a conductive material, and for example, can include metal such as Al, Ti, Cu, Cr, Mo, and W, but not limited thereto.

The external metal layer LSb can block external light which passes through the substrate and travels to the active layer ACT, and thus, can stabilize a driving characteristic of a transistor.

The external metal layer LSb can overlap the active layer ACT. For example, in each of the first to third subpixels SP1 to SP3, a width of the external metal layer LSb in a direction from one end thereof adjacent to the first source-drain region ASDa to the other end thereof adj acent to the second source-drain region ASDb can be greater than that of the channel region CH. Therefore, the entire channel region CH can overlap the external metal layer LSb. For example, as in FIGS. 3 to 5, both ends of the external metal layer LSb can be disposed at portions overlapping the first and second source-drain regions ASDa and ASDb. However, the present disclosure is not limited thereto, and based on the demand for design, the both ends of the external metal layer LSb can be disposed outside the first and second source-drain regions ASDa and ASDb. For example, the first and second source-drain regions ASDa and ASDb can partially overlap with the external metal layer LSb, alternatively, the entire of the first and second source-drain regions ASDa and ASDb can overlap with the external metal layer LSb, but not limited thereto.

The external metal layer LSb can be electrically connected to one of the gate electrode G and one of the first and second source-drain regions ASDa and ASDb. For example, as illustrated in FIGS. 3 to 5, the external metal layer LSb can be electrically connected to the gate electrode G through a connection line CTb, but not electrically connected to the first and second source-drain regions ASDa and ASDb.

The external metal layer LSb can be electrically connected to the gate electrode G, and thus, when a turn-on voltage is applied to the gate electrode G, an electric field applied to the channel region CH can be reinforced, and the amount of carriers moving along the channel region CH can increase, thereby enhancing an on current value of the driving transistor TR2. Accordingly, the driving transistor TR2 can generate a driving current which is relatively higher than a structure where an external metal layer is not connected to a gate electrode.

The internal metal layer LSa can include a conductive material, and for example, can include metal such as Al, Ti, Cu, Cr, Mo, and W, but not limited thereto.

The internal metal layer LSa can be disposed between the active layer ACT and the external metal layer LSb and can be spaced apart from each of the active layer ACT and the external metal layer LSb. The internal metal layer LSa and the active layer ACT can be insulated from each other by the buffer layer BUF, and the internal metal layer LSa and the external metal layer LSb can be insulated from each other by the buffer layer BUF.

For example, the internal metal layer LSa and the external metal layer LSb can be insulated from each other by the first buffer layer BUF1, and the internal metal layer LSa and the active layer ACT can be insulated from each other by the second buffer layer BUF2. The first and second buffer layers BUF1 and BUF2 can include an insulating material. For example, the first and second buffer layers BUF1 and BUF2 can include an inorganic insulating material such as SiOx, SiNx or SiOxNy.

The internal metal layer LSa can overlap the active layer ACT and the external metal layer LSb, between the active layer ACT and the external metal layer LSb.

A width of the internal metal layer LSa in a direction from one end thereof adjacent to the first source-drain region ASDa to the other end thereof adjacent to the second source-drain region ASDb can be less than that of the external metal layer LSb.

Here, one end of the internal metal layer LSa disposed at an opposite side of a non-overlap region NOA of the external metal layer LSb can be disposed at a portion overlapping one of the first and second source-drain regions ASDa and ASDb. In FIGS. 3 to 5, a case where one end of the internal metal layer LSa overlaps the first source-drain region ASDa is illustrated for example. However, this can be an example embodiment, and based on the demand for design, the one end of the internal metal layer LSa can be disposed outside the first source-drain region ASDa. For example, the first source-drain region ASDa can partially overlap with the internal metal layer LSa, alternatively, the entire first source-drain region ASDa can overlap with the internal metal layer LSa, but not limited thereto

In FIGS. 3 to 5, a case where an end of one side of the internal metal layer LSa is disposed to be substantially equally aligned at an end of one side of the external metal layer LSb within a design error range is illustrated for example, but the present disclosure is not limited thereto. For example, an end of one side of the internal metal layer LSa may not align with an end of one side of the external metal layer LSb.

Based on an interval between the internal metal layer LSa and the active layer ACT and an internal between the external metal layer LSb and the active layer ACT, as illustrated in FIGS. 3 to 5, a thickness of the internal metal layer LSa can be greater than that of the external metal layer LSb. Accordingly, a magnitude of an electric field applied to the active layer ACT by the internal metal layer LSa in a vertical direction can be similar to a magnitude of an electric field applied to the active layer ACT by the external metal layer LSb in a vertical direction. For example, a magnitude of an electric field applied to the active layer ACT by the internal metal layer LSa in a vertical direction can be same to a magnitude of an electric field applied to the active layer ACT by the external metal layer LSb in a vertical direction. However, the present disclosure is not limited thereto, and based on the demand for design, a thickness can differ from the illustration.

The internal metal layer LSa can be electrically connected to the other one of the gate electrode GI and one of the first and second source-drain regions ASDa and ASDb. For example, as illustrated in FIGS. 3 to 5, in a case where the external metal layer LSb is electrically connected to the gate electrode G, the internal metal layer LSa can be electrically connected to one of the first and second source-drain regions ASDa and ASDb. In FIGS. 3 to 5, a case where the internal metal layer LSa is electrically connected to the first source-drain region ASDa through a connection line CTa is illustrated for example. However, unlike this, the internal metal layer LSa can be connected to the second source-drain region ASDb. For example, in a case where the external metal layer LSb is electrically connected to the gate electrode G, the internal metal layer LSa can be connected to the second source-drain region ASDb.

The internal metal layer LSa can be electrically connected to the first source-drain region ASDa or the second source-drain region ASDb, and thus, a driving characteristic of a transistor can be enhanced. In more detail, in a case where the internal metal layer LSa is electrically connected to the first source-drain region ASDa or the second source-drain region ASDb, an S-factor of a transistor can be enhanced, and a gray level can be more precisely expressed, thereby enhancing image quality.

In each of the first to third subpixels SP1 to SP3, a width of the external metal layer LSb can be greater than that of the internal metal layer LSa. Accordingly, a width of the external metal layer LSb overlapping the active layer ACT can differ from a width of the internal metal layer LSa overlapping the active layer ACT. For example, a width of the external metal layer LSb overlapping the active layer ACT can be greater than a width of the internal metal layer LSa overlapping the active layer ACT.

In the driving transistor TR2 included in each of the first to third subpixels SP1 to SP3, the external metal layer LSb can include an overlap region OA and a non-overlap region NOA. The overlap region OA can denote a region, overlapping the internal metal layer LSa, of a region of the external metal layer LSb overlapping the active layer ACT, and the non-overlap region NOA can denote a region, which does not overlap the internal metal layer LSa, of the region of the external metal layer LSb overlapping the active layer ACT.

In FIGS. 3 to 5, a case where a width of the active layer ACT is greater than that of the external metal layer LSb is illustrated for example, but the present disclosure is not limited thereto. For example, based on the demand for design, a width of the external metal layer LSb can be greater than that of the active layer ACT. In this case, a definition of each of the overlap region OA and the non-overlap region NOA can be equal. However, a width of the external metal layer LSb can be greater than that of the active layer ACT, and thus, a sum of widths of the overlap region OA and the non-overlap region NOA of the external metal layer LSb can be limited to a width range of the active layer ACT. For example, a sum of widths of the overlap region OA and the non-overlap region NOA of the external metal layer LSb can be equal to a width of the active layer ACT.

In the present disclosure, a width of the non-overlap region NOA of the external metal layer LSb can be differently provided for each of subpixels SP emitting different lights. For example, in the present disclosure, a width of the non-overlap region NOA of the external metal layer LSb can be differently set based on a characteristic of emitted light and an emission characteristic of a light emitting device in each subpixel SP, and thus, image quality can be more enhanced.

When one unit pixel includes three subpixels (for example, first to third subpixels), as in FIGS. 3 to 5, a width of the non-overlap region NOA of the external metal layer LSb can differ in the driving transistor TR2 included in each of the first to third subpixels SP1 to SP3.

As in FIG. 3, a first width W1 of a non-overlap region NOA of an external metal layer LSb in a first subpixel SP1 emitting green (G) light can differ from a second width W2 of a non-overlap region NOA of an external metal layer LSb in a second subpixel SP2 emitting blue (B) light.

For example, the first width W1 of the non-overlap region NOA of the external metal layer LSb in a driving transistor TR2 of the first subpixel SP1 illustrated in FIG. 3 can be less than the second width W2 of the non-overlap region NOA of the external metal layer LSb in a driving transistor TR2 of a second subpixel SP2 illustrated in FIG. 4.

As illustrated in FIG. 3, an end of one side of the internal metal layer LSa in the first subpixel SP1 emitting green (G) light can overlap a first source-drain region ASDa, and an end of the other side of the internal metal layer LSa adjacent to the non-overlap region NOA of the external metal layer LSb can overlap a second source-drain region ASDb.

As illustrated in FIG. 4, one side of an internal metal layer LSa in a second subpixel SP2 emitting blue (B) light can overlap a first source-drain region ASDa, and an end of the other side of the internal metal layer LSa adjacent to a non-overlap region NOA of an external metal layer LSb can overlap a channel region CH.

Moreover, as in FIG. 5, a third width W3 of a non-overlap region NOA, which does not overlap an internal metal layer LSa, of a region of an external metal layer LSb overlapping an active layer ACT in a third subpixel SP3 emitting red (R) light can differ from the first width W1 of FIG. 3 and the second width W2 of FIG. 4.

For example, as illustrated in FIG. 5, the third width W3 of the non-overlap region NOA of the external metal layer LSb in the third subpixel SP3 can be greater than the first width W1 and less than the second width W2.

As described above, in the present disclosure, a width of a non-overlap region NOA of an external metal layer LSb can be differently set for each subpixel SP and can thus differ from a width of an internal metal layer LSa overlapping an active layer ACT. For example, the width of the internal metal layer LSa overlapping the active layer ACT can be inversely proportional to that of the non-overlap region NOA of the external metal layer LSb. Accordingly, as a width of the non-overlap region NOA of the external metal layer LSb increases, the width of the internal metal layer LSa overlapping the active layer ACT can decrease, and as the width of the non-overlap region NOA of the external metal layer LSb decreases, the width of the internal metal layer LSa overlapping the active layer ACT can increase.

Therefore, the present disclosure can be configured so that a magnitude of an electric field applied to the active layer ACT by the internal metal layer LSa differs from that of an electric field applied to the active layer ACT by the external metal layer LSb, for each subpixel SP.

Because the internal metal layer LSa is disposed in the overlap region OA of the external metal layer LSb, an electric field based on the external metal layer LSb can be blocked by the internal metal layer LSa, and an electric field based on the internal metal layer LSa can be applied to the active layer ACT. Further, because the internal metal layer LSa is not disposed in the non-overlap region NOA of the external metal layer LSb, an electric field based on the external metal layer LSb can be applied to the active layer ACT.

A magnitude of an influence of the internal metal layer LSa on the active layer ACT can be proportional to a width of the overlap region OA overlapping the internal metal layer LSa and the active layer ACT, and a magnitude of an influence of the external metal layer LSb on the active layer ACT can be proportional to a width of the non-overlap region NOA of the external metal layer LSb.

As a width of the non-overlap region NOA of the external metal layer LSb decreases, an S-factor of a driving transistor TR2 can be enhanced, a threshold voltage Vth can be shifted in a (+) direction, and an on current value can be restricted.

Moreover, as a width of the non-overlap region NOA of the external metal layer LSb increases, an on current value of the driving transistor TR2 can be enhanced, the threshold voltage Vth can be shifted in a (-) direction, and the S-factor can decrease.

In the present disclosure, in a first subpixel SP1 emitting green (G) light which is relatively high in weight when expressing luminance in expressing white, as in FIG. 3, a non-overlap region NOA of an external metal layer LSb can have a first width W1 which is relatively less than the second width W2 and the third width W3 of the second and third subpixels SP2 and SP3. Therefore, a section needed for changing a driving current from an off status to an on status in the first subpixel SP1 can be longer than the second and third subpixels SP2 and SP3. In this case, as an S-factor of the first subpixel SP1 is set to be relatively greater than an S-factor of each of the second and third subpixels SP2 and SP3, a grayscale expression section of the first subpixel SP1 which is large in luminance control can be secured, and control can be more stably and finely performed when displaying full white.

Moreover, in the present disclosure, based on that a threshold voltage Vth of a light emitting device emitting blue (B) light is higher than a threshold voltage Vth of a light emitting device emitting green (G) or red (R) light, as in FIG. 4, the non-overlap region NOA of the external metal layer LSb in the second subpixel SP2 emitting blue (B) light can have the second width W2 which is relatively greater than the first width W1 and the third width W3 of the first and third subpixels SP2 and SP3, so that an on current value of a driving transistor of the second subpixel SP2 emitting blue (B) light is largest. Accordingly, an on current value of a saturation status when turning on the driving transistor TR2 of the second subpixel SP2 can be set to be relatively high. For example, an on current value of a saturation status when turning on the driving transistor TR2 of the second subpixel SP2 can be greater than each of an on current value of a saturation status when turning on the driving transistor TR2 of the first subpixel SP1 and an on current value of a saturation status when turning on the driving transistor TR2 of the third subpixel SP3.

For example, based on that a threshold voltage Vth of a light emitting device emitting blue light having a short wavelength is higher than a threshold voltage Vth of a light emitting device emitting green (G) or red (R) light having a long wavelength, the non-overlap region NOA of the external metal layer LSb can be differently set, and thus, an on current value of a saturation status when turning on the driving transistor TR2 can be set based on each subpixel.

Moreover, even when the same gate voltage as a voltage applied to the driving transistor TR2 of each of the first and third subpixels SP1 and SP3 is applied to the driving transistor TR2 of the second subpixel SP2, the driving transistor TR2 of the second subpixel SP2 can generate a driving current which is relatively higher. Accordingly, a sense of color can be enhanced so that the luminance of blue light emitted from the second subpixel SP2 is equal to that of green light or red light.

Moreover, based on that a light emitting device emitting red light has an emission characteristic between a light emitting device emitting green light and a light emitting device emitting blue light, in a third subpixel SP3 emitting red light, as in FIG. 5, a non-overlap region NOA of an external metal layer LSb can have a third width W3 which is greater than a first width W1 of a first subpixel SP1 and less than a second width W2 of a second subpixel SP2, and thus, an S-factor or an on current value of the third subpixel SP3 can have a value between the first subpixel SP1 and the second subpixel SP2.

Therefore, in the present disclosure, non-overlap regions NOA of external metal layers LSb in subpixels SP can have different widths, and thus, a sense of color of a unit pixel can be more enhanced, and grayscale expression can be more accurately implemented, thereby enhancing image quality.

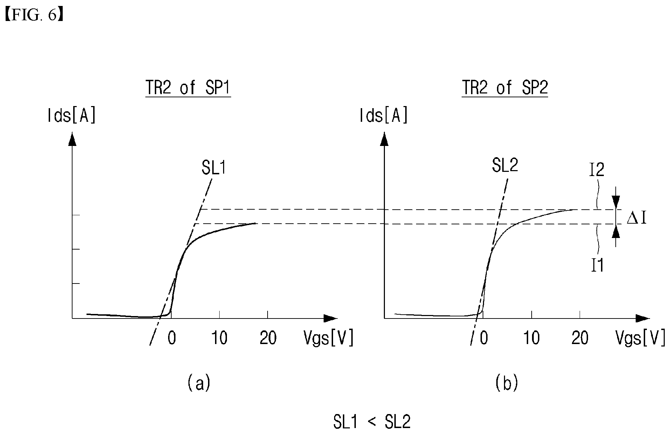

FIG. 6 is a diagram for describing an electrical characteristic curve of a driving transistor TR2 for each subpixel SP according to an example embodiment of the present disclosure.

Particularly, (a) of FIG. 6 shows an electrical characteristic curve of a driving transistor TR2 of a first subpixel SP1 emitting green light, and (b) of FIG. 6 shows an electrical characteristic curve of a driving transistor TR2 of a second subpixel SP2 emitting blue light.

In (a) and (b) of FIG. 6, SL1 represents a slope of a variation rate of a drain-source current Ids with respect to a gate-source voltage Vgs in a transition section of a driving transistor TR2 included in a first subpixel SP1, and SL2 represents a slope of a variation rate of a drain-source current Ids with respect to a gate-source voltage Vgs in a transition section of a driving transistor TR2 included in a second subpixel SP2.

Further, I1 can be a drain-source current Ids value when the gate-source voltage Vgs of the driving transistor TR2 included in the first subpixel SP1 is the maximum (for example, 20 V), and I2 can be a drain-source current Ids value when the gate-source voltage Vgs of the driving transistor TR2 included in the second subpixel SP2 is the maximum (for example, 20 V).

In the present disclosure, a non-overlap region NOA of an external metal layer LSb included in a first subpixel SP1 can have a first width W1 which is relatively small, and thus, as illustrated in FIG. 6, in a transition section, a slope SL1 of an electrical characteristic curve of the first subpixel SP1 can have a value which is less than that of a slope SL2 of an electrical characteristic curve of the second subpixel SP2.

An S-factor can be calculated as an inverse number value of a slope of an electrical characteristic curve in a transition section, and thus, in the present disclosure, an S-factor of the first subpixel SP1 can have a value which is greater than that of an S-factor of the second subpixel SP2. For example, when a first width W1 of a non-overlap region NOA of an external metal layer LSb included in a first subpixel SP1 is smaller than a second width W2 of a non-overlap region NOA of an external metal layer LSb included in a second subpixel SP2, in a transition section, a value of a slope SL1 of an electrical characteristic curve of the first subpixel SP1 is less than that of a slope SL2 of an electrical characteristic curve of the second subpixel SP2, and value of an S-factor of the first subpixel SP1 is greater than that of an S-factor of the second subpixel SP2. Accordingly, in the present disclosure, grayscale expression of the first subpixel SP1 emitting green light can be more precisely and accurately implemented.

Moreover, a non-overlap region NOA of an external metal layer LSb included in a second subpixel SP2 can have a second width W2 which is relatively large, and thus, as illustrated in FIG. 6, when a gate-source voltage Vgs is the maximum in an electrical characteristic curve of each of the first and second subpixels SP1 and SP2, a drain-source current value I2 of the second subpixel SP2 can have a value which is greater than a drain-source current value I1 of the first subpixel SP1. As described above, the present disclosure can more enhance an on current value of the second subpixel SP2, and thus, can more enhance the emission luminance of the second subpixel SP2 emitting blue light, and can more improve the power consumption of the second subpixel SP2.

Moreover, although not clearly illustrated in (b) of FIG. 6, a non-overlap region NOA of an external metal layer LSb included in a second subpixel SP2 can have a second width W2 which is relatively large, and thus, an electrical characteristic curve of a driving transistor TR2 of the second subpixel SP2 can be shifted in a (-) direction with respect to an electrical characteristic curve of a driving transistor TR2 of the first subpixel SP1.

Moreover, a non-overlap region NOA of an external metal layer LSb included in a third subpixel SP3 can have a third width W3 which is greater than a first width W1 of a first subpixel SP1 and less than a second width W2 of a second subpixel SP2, and thus, an S-factor or an on current value of the third subpixel SP3 can have a value between the first subpixel SP1 and the second subpixel SP2. For example, when third width W3 of a non-overlap region NOA of an external metal layer LSb included in a third subpixel SP3 is greater than a first width W1 of a first subpixel SP1 and less than a second width W2 of a second subpixel SP2, in a transition section, a value of a slope SL3 of an electrical characteristic curve of the third subpixel SP3 is greater than a value of a slope SL1 of an electrical characteristic curve of the first subpixel SP1 and less than a value of a slope SL2 of an electrical characteristic curve of the second subpixel SP2, and a value of an S-factor of the third subpixel SP3 is less than a value of an S-factor of the first subpixel SP1 and greater than a value of an S-factor of the second subpixel SP2.

As described above, in the present disclosure, because non-overlap regions NOA of external metal layers LSb in subpixels SP have different widths, an S-factor or an on current value of each subpixel SP can be more enhanced, and thus, grayscale expression can be more accurately implemented, and a sense of color can be enhanced, thereby enhancing image quality.

Hereinafter, an example where the driving transistor TR2 described above with reference to FIGS. 3 to 5 is applied to a display apparatus will be described.

FIG. 7 is a diagram for describing an example embodiment where the transistor of the first subpixel SP1 illustrated in FIG. 3 is applied to a display apparatus.

In FIG. 7, in a case where the subpixel SP illustrated in (a) of FIG. 2 is applied to a display apparatus, an example where the driving transistor of the first subpixel SP1 of FIG. 3 emitting green (G) light is applied is illustrated. The transistor of the second subpixel SP2 illustrated in FIG. 4 and the transistor of the third subpixel SP3 illustrated in FIG. 5 can be applied to a display apparatus, based on the same method as FIG. 7.

In detail, in a case where the driving transistor of FIG. 4 or the driving transistor of FIG. 5 is applied, a width of a region, which does not overlap the internal metal layer LSa, of the external metal layer LSb in FIG. 7 can be changed to the width W2 of FIG. 4 or the width W3 of FIG. 5, and the other portion can be the same as FIG. 7.

Moreover, a configuration where the external metal layer LSb is connected to a gate electrode G of a driving transistor is omitted in FIG. 7, but as described above with reference to FIGS. 3 to 5, the external metal layer LSb can be connected to the gate electrode G of the driving transistor through a connection line CTb.

In the display apparatus illustrated in FIG. 7, a cross-sectional surface of a first subpixel SP1 region emitting green is illustrated, and thus, as described above with reference to FIG. 3, a structure of each of a driving transistor, an internal metal layer LSa, and an external metal layer LSb of a first subpixel emitting green light can be applied to the first subpixel SP1 region. Therefore, in the display apparatus, as described above with reference to FIG. 4, a structure of each of a driving transistor, an internal metal layer LSa, and an external metal layer LSb of a second subpixel SP2 emitting blue light can be applied to a second subpixel SP2 region emitting blue light. Further, in the display apparatus, as described above with reference to FIG. 5, a structure of each of a driving transistor, an internal metal layer LSa, and an external metal layer LSb of a third subpixel SP3 emitting red light can be applied to a third subpixel SP3 region emitting red light.

Hereinafter, as illustrated in FIG. 7, a case where a display panel is a first subpixel SP1 region emitting green light will be described for example.

In describing FIG. 7, descriptions which are the same as or similar to the descriptions of FIGS. 1 to 6 are omitted, and the other configuration will be mainly described.

As illustrated in FIG. 7, a display apparatus to which a driving transistor of a first subpixel SP1 is applied can include a substrate 100, a first insulation layer 110, a second insulation layer 130, a device buffer layer 140, a first transistor TR1 which is a switching transistor, a second transistor TR2 which is a driving transistor of the first subpixel SP1, an internal metal layer LSa, an external metal layer LSb, a gate insulation layer 150, an interlayer insulation layer 200, a first planarization layer 300, a second planarization layer 400, first and second center electrodes CE1 and CE2, a bank insulation layer 500, and a light emitting device 600, but not limited thereto.

A cross-sectional structure of the display apparatus of FIG. 7 can be an example for understanding the present disclosure, and the present disclosure is not limited thereto.

The substrate 100 can include a plastic material having flexibility and can have a flexible characteristic, for example, the substrate can include a flexible polymer film. For example, the flexible polymer film can be made of any one of polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), cyclic olefin copolymer(COC), triacetylcellulose(TAC), polyvinyl alcohol(PVA), and polystyrene(PS), and the present disclosure is not limited thereto. Moreover, the substrate 100 can include a glass material of a thin thickness having flexibility.

The substrate 100 can have a multi-layer structure including an insulating material. For example, as illustrated in FIG. 7, the substrate 100 can have a structure where a first substrate layer 101, a substrate insulation layer 102, and a second substrate layer 103 are sequentially stacked, and the first and second substrate layers 101 and 103 can include a polymer material such as polyimide (PI). The substrate insulation layer 102 can include an insulating material. For example, the substrate insulation layer 102 can be formed of a single layer or multiple layers of silicon oxide (SiOx), silicon nitride (SiNx), or silicon oxynitride (SiOxNy), which is an inorganic film material, but example embodiments of the present disclosure are not limited thereto.

A first insulation layer 110 can be disposed in an active area AA and a non-active area NA of the substrate 100. The first insulation layer 110 can be referred to as a buffer layer. The first insulation layer 110 can be disposed on the substrate 100, can protect structures on the substrate 100 vulnerable to water transmission from water penetrating through the substrate 100, and can planarize a surface of the substrate 100. The first insulation layer 110 can be formed of an inorganic single layer, or as in FIG. 7, the first insulation layer 110 can include a 1a^{th} insulation layer 111 and a 1b^{th} insulation layer 112, where a plurality of inorganic layers are formed in a multi-layer structure. For example, each of the 1a^{th} insulation layer 111 and the 1b^{th} insulation layer 112 can include one or more inorganic layers of SiOx, SiNx, and SiOxNy. For example, each of the 1a^{th} insulation layer 111 and the 1b^{th} insulation layer 112 can be configured as a single layer or multi-layer of silicon oxide (SiOx), silicon nitride (SiNx), or silicon oxynitride (SiOxNy), for example, each of the 1a^{th} insulation layer 111 and the 1b^{th} insulation layer 112 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

A second insulation layer 130 can be disposed on the first insulation layer 110. The second insulation layer 130 can function as an interlayer insulation layer 200 of each transistor configuring a gate driver disposed in the non-active area NA. The second insulation layer 130 can include an inorganic material. The inorganic material can include, for example, silicon oxide (SiOx), silicon nitride (SiNx), or silicon oxynitride (SiOxNy), but the example embodiments of the present disclosure are not limited thereto.

To stabilize a driving characteristic of the first transistor TR1 which is a switching transistor illustrated in FIG. 2, for example, a bottom gate electrode BOT connected to a gate electrode G can be provided between the first insulation layer 110 and the second insulation layer 130.

The bottom gate electrode BOT can include a metal material which differs from that of the gate electrode SG of the first transistor TR1 which is a switching transistor.

The device buffer layer 140 can be provided on the second insulation layer 130. The device buffer layer 140 can fully cover the active area AA of the substrate 100 and can include an insulating material. For example, the device buffer layer 140 can include an inorganic insulating material such as silicon oxide (SiOx), silicon nitride (SiNx), or silicon oxynitride (SiOxNy), but the example embodiments of the present disclosure are not limited thereto. The device buffer layer 140, for example, as in FIG. 7, can include a multi-layer structure where a first device buffer layer 141 and a second device buffer layer 142 are stacked. The first device buffer layer 141 and the second device buffer layer 142 can include the same material, or can include different materials.

An active layer SACT of the first transistor TR1 which is a switching transistor and an active layer ACT of the second transistor TR2 which is a driving transistor can be disposed on the device buffer layer 140. As in FIG. 7, when the first and second transistors TR1 and TR2 are disposed on the same device buffer layer 140, a manufacturing process can be more simplified.

However, all switching transistors and a driving transistor may not be formed on the same device buffer layer 140, and the present disclosure is not limited thereto. For example, some of a plurality of switching transistors and a driving transistor can be formed on the same device buffer layer 140, or a cross-sectional structure where only one transistor of a switching transistor and a driving transistor is formed on the device buffer layer 140 can be variously modified.

The device buffer layer 140 of FIG. 7 can be the same as the buffer layer BUF described above with reference to FIGS. 3 to 5. Therefore, the first device buffer layer 141 of FIG. 7 can be the same as the first buffer layer BUF1 of FIGS. 3 to 5, and the second device buffer layer 142 of FIG. 7 can be the same as the second buffer layer BUF2 of FIGS. 3 to 5. For example, each of the first device buffer layer 141 and the second device buffer layer 142 can be configured as a single layer or multi-layer of silicon oxide (SiOx), silicon nitride (SiNx), or silicon oxynitride (SiOxNy), for example, each of the first device buffer layer 141 and the second device buffer layer 142 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

Here, the external metal layer LSb described above with reference to FIGS. 3 to 5 can be disposed between the second insulation layer 130 and the first device buffer layer 141, and the internal metal layer LSa can be disposed between the first device buffer layer 141 and the second device buffer layer 142. The descriptions of the internal metal layer LSa and the external metal layer LSb can be the same as the descriptions of FIGS. 3 to 5.

The first transistor TR1 which is a switching transistor and the second transistor TR2 which is a driving transistor can be disposed on the device buffer layer 140.

As in FIG. 7, when the first and second transistors TR1 and TR2 are provided on the same device buffer layer 140, a process can be simplified, production energy can be reduced, and the occurrence of a greenhouse gas caused by a manufacturing process can decrease, thereby implementing ESG.

The first transistor TR1 which is a switching transistor can include the active layer SACT, the gate electrode SG, and a source-drain electrode SSD, which are disposed on the device buffer layer 140.

The active layer SACT of the first transistor TR1 can include an oxide semiconductor material. The oxide semiconductor material included in the active layer SACT can include, for example, at least one of InZnO (IZO)-based, InGaO (IGO)-based, InSnO (ITO)-based, InGaZnO (IGZO)-based, InGaZnSnO (IGZTO)-based, GaZnSnO (GZTO)-based, GaZnO (GZO)-based, InSnZnO (ITZO)-based, and FeInZnO (FIZO)-based oxide semiconductor materials.

Although not shown, the active layer SACT of the first transistor TR1 can include a channel region CH and a source-drain region at both sides of the channel region CH, the channel region CH can be relatively low in concentration of dopants, and the source-drain region can be relatively high in concentration of dopants. For example, a concentration of dopants of the source-drain region is greater than a concentration of dopants of the channel region CH.

The gate electrode SG and the active layer SACT of the first transistor TR1 can be insulated from each other by the gate insulation layer 150. The gate insulation layer 150 of FIG. 7 can be the same as the gate insulation layer GI described above with reference to FIGS. 3 to 5. For example, the gate insulation layer 150 can be configured as a single layer or multi-layer of silicon oxide (SiOx), silicon nitride (SiNx), or silicon oxynitride (SiOxNy), for example, the gate insulation layer 150 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

The gate electrode SG of the first transistor TR1 can be disposed on the gate insulation layer 150 to overlap the active layer SACT. The gate electrode SG can control an operation of forming a channel in the channel region CH of the active layer SACT, based on a voltage applied thereto.

The interlayer insulation layer 200 can be disposed on the gate electrode SG of the first transistor TR1. The interlayer insulation layer 200 of FIG. 7 can be the same as the interlayer insulation layer ILD described above with reference to FIGS. 3 to 5. For example, the interlayer insulation layer 200 can be configured as a single layer or multi-layer of silicon oxide (SiOx), silicon nitride (SiNx), or silicon oxynitride (SiOxNy), for example, the interlayer insulation layer 200 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

A source-drain electrode SSD and a gate connection electrode CSG of the first transistor TR1 can be disposed on the interlayer insulation layer 200.

The source-drain electrode SSD of the first transistor TR1 can be disposed on the interlayer insulation layer 200 of the first transistor TR1. The source-drain electrode SSD of the first transistor TR1 can include an electrode contacting one source-drain region of the active layer ACT and an electrode contacting the other source-drain region of the active layer ACT.

The source-drain electrode SSD of the first transistor TR1 can pass through the interlayer insulation layer 200 and the gate insulation layer 150 and can contact each of both source-drain regions of the active layer ACT. In FIG. 7, for convenience, the source-drain electrode SSD contacting one side of the active layer ACT is illustrated as an example, but the source-drain electrode contacts the other side.

The gate connection electrode CSG can connect the gate electrode SG and the bottom gate electrode BOT of the first transistor TR1 with each other. One end of the gate connection electrode CSG can pass through the interlayer insulation layer 200 and can contact the gate electrode SG, and the other end can pass through the interlayer insulation layer 200, the gate insulation layer 150, the device buffer layer 140, and the second insulation layer 130 and can be connected to the bottom gate electrode BOT.

The bottom gate electrode BOT can be connected to the gate electrode SG through the gate connection electrode CSG, and thus, the control of a channel region of the active layer ACT can be more quickly performed.

The switching transistor according to the present disclosure can include a lower metal layer which is disposed on the same layer as one of the internal metal layer LSa and the external metal layer LSb disposed under the driving transistor. In FIG. 7, for example, a case is illustrated where a lower metal layer disposed under the first transistor TR1 which is a switching transistor is the bottom gate electrode BOT, and the lower metal layer (bottom gate electrode) BOT is disposed on the same layer as the external metal layer LSb.

However, the present disclosure is not limited thereto. For example, unlike FIG. 7, a lower metal layer of the first transistor TR1 can be disposed on the same layer as the internal metal layer LSa. For example, the lower metal layer BOT can be disposed on the first device buffer layer 141 like the internal metal layer LSa.

Moreover, in FIG. 7, it is illustrated that a thickness of the lower metal layer BOT is greater than that of the external metal layer LSb, but the present disclosure is not limited thereto and unlike FIG. 7, a thickness of the lower metal layer BOT can be equal to that of one of the internal metal layer LSa and the external metal layer LSb, but not limited thereto.

The second transistor TR2 which is a driving transistor can be disposed on the device buffer layer 140 and can include a gate electrode G, an active layer ACT, and first and second source-drain electrodes SDa and SDb. As described above, the second transistor TR2 can be a driving transistor of the first subpixel SP1 emitting green light as illustrated in FIG. 3.

The active layer ACT can be disposed on the device buffer layer 140 and can be spaced apart from the internal metal layer LSa, and the active layer ACT can include a channel region CH and first and second source-drain regions ASDa and ASDb.

The gate electrode G can be disposed apart from the active layer ACT and can overlap the channel region CH. The gate electrode G and the active layer ACT can be insulated from each other by the gate insulation layer 150. As described above with reference to FIG. 3, the gate electrode G can be electrically connected to the external metal layer LSb.

The gate electrode G and the active layer ACT of the first transistor TR1 and the gate electrode G and the active layer ACT of the second transistor TR2 can be insulated from each other by the same gate insulation layer 150. The gate insulation layer 150 of FIG. 7 can be the same as the gate insulation layer GI described above with reference to FIGS. 3 to 5. For example, the gate insulation layer 150 can be configured as a single layer or multi-layer of silicon oxide (SiOx), silicon nitride (SiNx), or silicon oxynitride (SiOxNy), for example, the gate insulation layer 150 can be formed by inorganic film in a single layer or in multiple layers, for example, the inorganic film in a single layer can be a silicon oxide (SiOx) film, a silicon nitride (SiNx) film or a silicon oxynitride (SiOxNy), and inorganic films in multiple layers can formed by alternately stacking at least one of one or more silicon oxide (SiOx) films, one or more silicon nitride (SiNx) films and one or more silicon oxynitride (SiOxNy) films, and one or more amorphous silicon (a-Si), but the example embodiments of the present disclosure are not limited thereto.

The interlayer insulation layer 200 can be disposed on the gate electrode G of the second transistor TR2. First and second source-drain electrodes SDa and SDb of the second transistor TR2 can be disposed on the interlayer insulation layer 200 of the second transistor TR2.

One end of the first source-drain electrode SDa can pass through the interlayer insulation layer 200 and can contact the first source-drain region ASDa of the active layer ACT, and the other end of the first source-drain electrode SDa can pass through the interlayer insulation layer 200, the gate insulation layer, and the second buffer layer BUF2 and can be connected to one end of the internal metal layer LSa.

One end of the second source-drain electrode SDb can pass through the interlayer insulation layer 200 and can contact the second source-drain region ASDb of the active layer ACT, and the other end of the second source-drain electrode SDb can be electrically connected to an anode electrode of the light emitting device 600.

The external metal layer LSb of the first subpixel SP1 emitting green light can overlap the active layer ACT and the internal metal layer LSa. A non-overlap region NOA, which does not overlap the internal metal layer LSa, of a region of the external metal layer LSb overlapping the active layer ACT can have a first width W1 like FIG. 3.

However, in the second subpixel SP2 emitting blue light, as described above with reference to FIG. 4, a width of the non-overlap region NOA of the external metal layer LSb can have a second width W2 which is greater than the first width W1, and in the third subpixel SP3 emitting red light, as described above with reference to FIG. 5, the non-overlap region NOA of the external metal layer LSb can have a third width W3 which is greater than the first width W1 and less than the second width W2. For example, when third width W3 of a non-overlap region NOA of an external metal layer LSb included in a third subpixel SP3 is greater than a first width W1 of a first subpixel SP1 and less than a second width W2 of a second subpixel SP2, in a transition section, a value of a slope SL3 of an electrical characteristic curve of the third subpixel SP3 is greater than a value of a slope SL1 of an electrical characteristic curve of the first subpixel SP1 and less than a value of a slope SL2 of an electrical characteristic curve of the second subpixel SP2, and a value of an S-factor of the third subpixel SP3 is less than a value of an S-factor of the first subpixel SP1 and greater than a value of an S-factor of the second subpixel SP2.

The first planarization layer 300 and the second planarization layer 400 can be sequentially stacked on the first and second transistors TR1 and TR2.

The first planarization layer 300 and the second planarization layer 400 can remove a step height caused by a driving circuit. For example, an upper surface of the second planarization layer 400 facing the light emitting device OLED 600 can be a flat surface. The first planarization layer 300 and the second planarization layer 400 can include an insulating material. The first planarization layer 300 and the second planarization layer 400 can include a material having high flowability. For example, the first planarization layer 300 and the second planarization layer 400 can include an organic insulating material. The second planarization layer 400 can include a material which differs from that of the first planarization layer 300. Accordingly, in the display apparatus according to an example embodiment of the present disclosure, a step height caused by driving circuits can be effectively removed.

First and second center electrodes CE1 and CE2 of the second transistor TR2 can be disposed between the first planarization layer 300 and the second planarization layer 400. The first and second center electrodes CE1 and CE2 can include a conductive material. For example, each of the first and second center electrodes CE1 and CE2 can include metal such as Al, Cr, Cu, Ti, Mo, and W, but not limited thereto.

Although not shown, the first center electrode CE1 can electrically connect the first transistor TR1 to the second transistor TR2, or can electrically connect the first and second transistors TR1 and TR2 to another circuit configuration.

The second center electrode CE2 can electrically connect the second transistor TR2 to the light emitting device 600. For example, as in FIG. 7, the second center electrode CE2 can electrically connect the second source-drain electrode SDb of the second transistor TR2 to a first electrode (an anode electrode) 610 of the light emitting device 600.

A bank insulation layer 500 can be disposed on the second planarization layer 400.

The bank insulation layer 500 can include an insulating material. For example, the bank insulation layer 500 can include an organic insulating material. The bank insulation layer 500 can include a material which differs from that of each of the first planarization layer 300 and the second planarization layer 400. The bank insulation layer 500 can cover an edge of the first electrode 610 (for example, the anode electrode). The emission layer 620 and a second electrode 630 (for example, a cathode electrode) can be stacked on a partial region of the first electrode 610 exposed by the bank insulation layer 500. For example, the bank insulation layer 500 can define an emission region in each subpixel SP.

The bank insulation layer 500 can be formed of an opaque material (for example, black) in order to prevent light interference between adjacent pixels. In this case, the bank insulation layer 500 can include a light shielding material constituted by at least one of a color pigment, organic black, or carbon, without being limited thereto.

For example, the bank insulation layer 500 can be formed of an organic insulating material. The bank insulation layer 500 can be configured as a single layer or a multi-layer of the organic insulating material. For example, the plurality of banks BNK can be formed of a photoresist, polyimide (PI), or acryl-based material, but the example embodiments of present disclosure are not limited thereto.

Meanwhile, the bank insulation layer 500 can include an inorganic insulating material, such as silicon nitride (SiNx) or silicon oxide (SiOx), or the bank insulation layer 500 can be formed of black resin. However, the present disclosure is not limited thereto.

The light emitting device 600 can be disposed in the emission region and can include the first electrode 610, the emission layer 620, and the second electrode 630.

In the light emitting device (OLED) 600, for example, the first electrode 610 can function as an anode electrode and can include a conductive material. The first electrode 610 can have a high reflectance. For example, the first electrode 610 can include metal such as Al and silver (Ag), but not limited thereto. The first electrode 610 can have a multi-layer structure. For example, the first electrode 610 can have a structure where a reflective electrode including metal is disposed between transparent electrodes including a transparent conductive material such as indium tin oxide (ITO) or indium zinc oxide (IZO).

The emission layer 620 can generate light of luminance corresponding to a voltage difference between the first electrode 610 and the second electrode 630. For example, the emission layer 620 can include an emission material layer (EML) including an emission material. The emission material can include an organic material, an inorganic material, or a hybrid material. For example, the emission layer 620 can include an emission material layer including an organic material.

The emission layer 620 can include at least one of a first emission common layer disposed between first electrodes 610 and a second emission common layer disposed between second electrodes 630. Each of the first emission common layer and the second emission common layer can include at least one of a hole injection layer (HIL), a hole transport layer (HTL), an electron transport layer (ETL), and an electron injection layer (EIL), but not limited thereto.

The emission layer 620 can emit light of one color of red (R), green (G), and blue (B). The emission layer of the first subpixel SP1 can emit green light, the emission layer of the second subpixel SP2 can emit blue light, and the emission layer of the third subpixel SP3 can emit red light. In FIG. 7, the emission layer can emit green light.

The second electrode 630, for example, can function as a cathode electrode and can include a conductive material. The second electrode 630 can include a material which differs from that of the first electrode 610. For example, the second electrode 630 can be a transparent electrode including a transparent conductive material such as ITO or IZO. The second electrode 630 can have a transmittance which is higher than that of the first electrode 610. Accordingly, in the display apparatus according to an example embodiment of the present disclosure, light generated by the emission layer 620 can be emitted through the second electrode 630.

In FIG. 7, a case where the light emitting device 600 (OLED) is connected to the second transistor TR2 among the first transistor TR1 which is a switching transistor and the second transistor TR2 which is a driving transistor, disposed on the device buffer layer 140 is illustrated, but the present disclosure is not limited thereto.

As described above with reference to (b) of FIG. 2, when a third transistor TR3 which is a switching transistor is provided, the second transistor TR2 can be connected to the third transistor TR3, and the third transistor TR3 can be electrically connected to the light emitting device 600 (OLED).

As described above, in the display apparatus according to an example embodiment of the present disclosure, a width of a non-overlap region NOA of an external metal layer LSb connected to a driving transistor can be differently configured for each subpixel SP, and thus, an S-factor and an on current value of a transistor can be differently set for each subpixel SP, based on an emission characteristic of each subpixel. Accordingly, the quality of an image displayed by a display panel can be enhanced.

For example, as described above with reference to FIGS. 3 to 5, a width of a non-overlap region NOA of an external metal layer LSb can be differently set for each of subpixels SP emitting lights of different colors, in a state where an external metal layer LSb included in each of a plurality of subpixels SP is electrically connected to a gate electrode G, and an internal metal layer LSa is electrically connected to one of first and second source-drain regions ASDa and ASDb.

In detail, in the first subpixel SP1 including a green emission layer, a sense of color expressed by a unit pixel can be largely affected thereby, and thus, a non-overlap region NOA of an external metal layer LSb can be configured to have a relatively small first width W1 so that an S-factor relatively increases, for fine grayscale expression. Further, in the second subpixel SP2 including a blue emission layer, the luminance of light emitted by the same driving current can be lower than green or red, and thus, a non-overlap region NOA of an external metal layer LSb can be configured to have a relatively large second width W2 so that a relatively high driving current is generated with respect to the same gate-source voltage Vgs.

In the third subpixel SP3 including a red emission layer, a sense of color can be less affected thereby than green, and the luminance of light can be large, and thus, a non-overlap region NOA of an external metal layer LSb can be configured to have a third width W3 which is greater than the first width W1 and less than the second width W2.

Therefore, in the present disclosure, a width of a non-overlap region NOA of an external metal layer LSb can be differently configured so that an S-factor and an on current value are changed for each subpixel SP, thereby enhancing the image quality of a display panel.

Hereinabove, for example, a case has been described where a width of a non-overlap region NOA of an external metal layer LSb is differently set for each of subpixels SP emitting lights of different colors, in a state where an external metal layer LSb included in each of a plurality of subpixels SP is electrically connected to a gate electrode G, and an internal metal layer LSa is electrically connected to one of first and second source-drain regions ASDa and ASDb.

However, the present disclosure is not limited thereto and can be applied to a case where the internal metal layer LSa is electrically connected to one of the first and second source-drain regions ASDa and ASDb, and the external metal layer LSb is electrically connected to the gate electrode G.

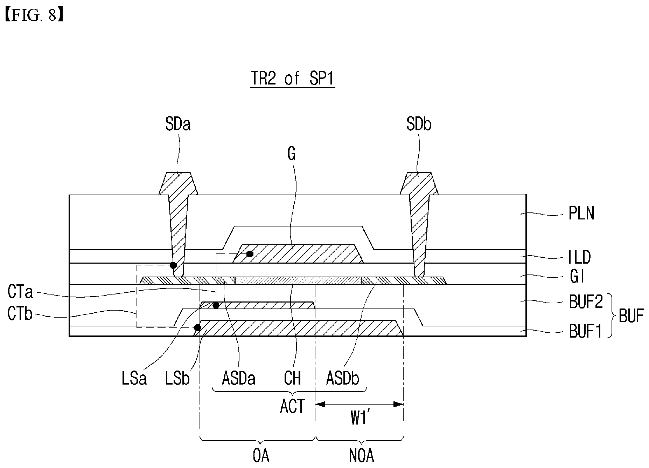

In this case, a width of a non-overlap region NOA of an external metal layer LSb can differ from the descriptions of FIGS. 3 to 7. Hereinafter, this will be described with reference to FIGS. 8 to 10.

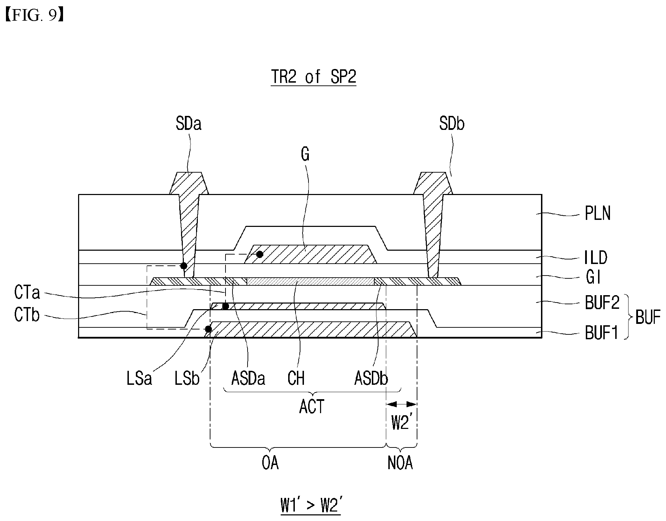

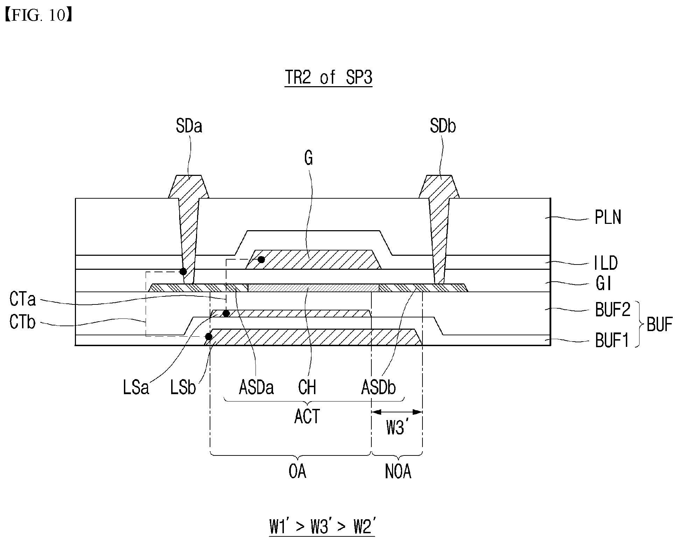

FIG. 8 is a diagram for describing another example embodiment of a transistor included in a first subpixel SP1 in a display apparatus according to the present disclosure, FIG. 9 is a diagram for describing another example embodiment of a transistor included in a second subpixel SP2 in a display apparatus according to the present disclosure, and FIG. 10 is a diagram for describing another example embodiment of a transistor included in a third subpixel SP3 in a display apparatus according to the present disclosure.

As illustrated in FIGS. 8 to 10, in a driving transistor TR2 included in each of first to third subpixels SP1 to SP3, an internal metal layer LSa can be electrically connected to a gate electrode G through a connection line CTa, and an external metal layer LSb can be electrically connected to one of first and second source-drain regions ASDa and ASDb through a connection line CTa. In FIGS. 8 to 10, a case where the external metal layer LSb is electrically connected to the first source-drain region ASDa is illustrated for example.

Here, a first subpixel SP1 of FIG. 8 can emit green light as in FIG. 3, a second subpixel SP2 of FIG. 9 can emit blue light as in FIG. 4, and a third subpixel SP3 of FIG. 10 can emit red light as in FIG. 5.

As described above, when an electrical connection structure between the internal metal layer LSa and the external metal layer LSb is formed in reverse with respect to FIGS. 3 to 5 described above, unlike the descriptions of FIGS. 3 to 5, the internal metal layer LSa can relatively largely affect an on current value of a transistor, and the external metal layer LSb can relatively largely affect an S-factor and a threshold voltage Vth of a transistor.

In this case, a width of a non-overlap region NOA of an external metal layer LSb can be differently provided in each of the first to third subpixels SP1 to SP3, and for example, a fourth width W1' of a non-overlap region NOA of an external metal layer LSb in the first subpixel SP1 can be greater than a fifth width W2' of a non-overlap region NOA of an external metal layer LSb in the second subpixel SP2, and a sixth width W3' of a non-overlap region NOA of an external metal layer LSb in the third subpixel SP3 can be provided to be greater than the fifth width W2' and less than the fourth width W1'.

Therefore, one side of an internal metal layer LSa in the first subpixel SP1 of FIG. 8 can overlap a first source-drain region ADSa, and an end of the other side of the internal metal layer LSa adjacent to the non-overlap region NOA of the external metal layer LSb can overlap a channel region CH.

Moreover, one side of an internal metal layer LSa in the second subpixel SP2 of FIG. 9 can overlap a first source-drain region ADSa, and an end of the other side of the internal metal layer LSa adjacent to the non-overlap region NOA of the external metal layer LSb can overlap a second source-drain region ASDb.

Therefore, the present disclosure can more enhance an S-factor of the first subpixel SP1 emitting green light and can more enhance an on current value of the second subpixel SP2 emitting blue light.

As described above, in the present disclosure, a driving transistor TR2 of each subpixel SP can include an internal metal layer LSa contacting a source-drain region and an external contact layer LSb contacting a gate electrode G, and a width of a non-overlap region NOA of the external metal layer LSb can be differently configured for each subpixel SP, and thus, an S-factor or an on current value of the driving transistor TR2 can be changed to be suitable for each subpixel SP, whereby image quality can be more enhanced.

In a display apparatus according to an example embodiment of the present disclosure, a width of a non-overlap region between an internal metal layer and an external metal layer each connected to a driving transistor can be differently configured for each subpixel, and thus, an S-factor and an on current value of a transistor can be differently set for each subpixel, based on an emission characteristic of each subpixel. Accordingly, the quality of an image displayed by a display panel can be enhanced.

The example embodiments of the present disclosure may not add a separate element, can include an internal metal layer and an external metal layer each connected to a driving transistor, and can differently set a width of a non-overlap region between the internal metal layer and the external metal layer, and thus, can enhance the image quality of a display apparatus, thereby implementing ESG. The following examples pertain to embodiments of the present disclosure.

Example 1: A display apparatus comprising: a substrate; a transistor disposed in each of a plurality of subpixels disposed in an active area of the substrate, the transistor including a channel region, an active layer including a first source-drain region and a second source-drain region at sides of the channel region, and a gate electrode overlapping the active layer; an external metal layer disposed between the active layer and the substrate to overlap the active layer; and an internal metal layer disposed between the active layer and the external metal layer to overlap the active layer and the external metal layer, wherein the plurality of subpixels comprise a first subpixel and a second subpixel configured to emit lights of different colors, and wherein a width of a non-overlap region, which does not overlap the internal metal layer, of a region of the external metal layer overlapping the active layer in the first subpixel differs from a width of a non-overlap region, which does not overlap the internal metal layer, of a region of the external metal layer overlapping the active layer in the second subpixel.

Example 2: The display apparatus of Example 1, wherein, in each of the first and second subpixels, the entire channel region overlaps the external metal layer, a width of the internal metal layer is less than a width of the external metal layer, and one end of the internal metal layer disposed at an opposite side of the non-overlap region of the external metal layer is disposed at a portion overlapping one of the first and second source-drain regions.

Example 3: The display apparatus of Example 1 or 2, wherein the transistor supplies a driving current to a light emitting device in a corresponding subpixel of the plurality of subpixels.

Example 4: The display apparatus of any of Examples 1 to 3, wherein, in each of the first and second subpixels, the external metal layer is electrically connected to one of the gate electrode and one of the first and second source-drain regions, and the internal metal layer is electrically connected to the other of the gate electrode and one of the first and second source-drain regions.

Example 5: The display apparatus of Example 4, wherein, in each of the first and second subpixels, the external metal layer is electrically connected to the gate electrode, and the internal metal layer is electrically connected to one of the first and second source-drain regions.

Example 6: The display apparatus of Example 4, wherein, in each of the first and second subpixels, the external metal layer is electrically connected to one of the first and second source-drain regions, and the internal metal layer is electrically connected to the gate electrode.

Example 7: The display apparatus of any of Examples 1 to 4, wherein, in each of the first and second subpixels, the internal metal layer is electrically connected to one of the first and second source-drain regions, and the external metal layer is electrically connected to the gate electrode, the first subpixel is configured to emit green light, and the second subpixel is configured to emit blue light, and a first width of the non-overlap region of the external metal layer in the first subpixel is less than a second width of the non-overlap region of the external metal layer in the second subpixel.

Example 8: The display apparatus of Example 7, wherein an end of one side of the internal metal layer in the first subpixel overlaps the first source-drain region, and an end of another side of the internal metal layer adjacent to the non-overlap region of the external metal layer overlaps the second source-drain region, and an end of one side of the internal metal layer in the second subpixel overlaps the first source-drain region, and an end of another side of the internal metal layer adj acent to the non-overlap region of the external metal layer overlaps the channel region.

Example 9: The display apparatus of Example 7 or 8, wherein the plurality of subpixels further comprise a third subpixel configured to emit light of a color which differs from the first and second subpixels, and a third width of a non-overlap region, which does not overlap the internal metal layer, of a region of the external metal layer overlapping the active layer in the third subpixel differs from the first width and the second width.

Example 10: The display apparatus of Example 9, wherein the third subpixel emits red light, and the third width of the non-overlap region of the external metal layer in the third subpixel is greater than the first width and less than the second width.

Example 11: The display apparatus of any of Examples 1 to 4, wherein, in each of the first and second subpixels, the internal metal layer is electrically connected to the gate electrode, and the external metal layer is electrically connected to one of the first and second source-drain regions, the first subpixel emits green light, and the second subpixel emits blue light, and a fourth width of the non-overlap region of the external metal layer in the first subpixel is greater than a fifth width of the non-overlap region of the external metal layer in the second subpixel.

Example 12: The display apparatus of Example 11, wherein an end of one side of the internal metal layer in the first subpixel overlaps the first source-drain region, and an end of another side of the internal metal layer adjacent to the non-overlap region of the external metal layer overlaps the channel region, and an end of one side of the internal metal layer in the second subpixel overlaps the first source-drain region, and an end of another side of the internal metal layer adjacent to the non-overlap region of the external metal layer overlaps the second source-drain region.

Example 13: The display apparatus of Example 11 or 12, wherein the plurality of subpixels further comprise a third subpixel configured to emit light of a color which differs from the lights of the colors emitted by the first and second subpixels, and a sixth width of the non-overlap region of the external metal layer in the third subpixel differs from the fourth width and the fifth width.

Example 14: The display apparatus of Example 13, wherein the third subpixel is configured to emit red light, and the sixth width of the non-overlap region of the external metal layer in the third subpixel is greater than the fifth width and is less than the fourth width.

Example 15: The display apparatus of any of Examples 1 to 14, wherein the active layer comprises an oxide semiconductor material.

Example 16: A display apparatus comprising: a substrate; a transistor disposed in each of a plurality of subpixels disposed in an active area of the substrate, the transistor including a channel region, a first active layer including a first source-drain region and a second source-drain region at sides of the channel region, and a first gate electrode overlapping the first active layer; an external metal layer disposed between the first active layer and the substrate to overlap the first active layer; an internal metal layer disposed between the first active layer and the external metal layer to overlap the first active layer and the external metal layer, wherein the plurality of subpixels comprise a first subpixel and a second subpixel configured to emit lights of different colors, and wherein a width of a non-overlap region, which does not overlap the internal metal layer, of a region of the external metal layer overlapping the first active layer in the first subpixel differs from a width of a non-overlap region, which does not overlap the internal metal layer, of a region of the external metal layer overlapping the first active layer in the second subpixel; and a switching transistor disposed in each of the plurality of subpixels disposed in the active area of the substrate, the switching transistor including a second active layer, a second gate electrode overlapping the second active layer, and a lower metal layer disposed on a same layer as one of the internal metal layer and the external metal layer.

Example 17: The display apparatus of Example 16, wherein the lower metal layer is connected to the second gate electrode via a gate connection electrode.

Example 18: The display apparatus of Example 16 or 17, wherein a thickness of the lower metal layer is same as a thickness of one of the internal metal layer and the external metal layer.

Example 19: The display apparatus of any of Examples 16 to 18, wherein, in each of the first and second subpixels, the internal metal layer is electrically connected to one of the first and second source-drain regions, and the external metal layer is electrically connected to the gate electrode, the first subpixel is configured to emit green light, and the second subpixel is configured to emit blue light, and a first width of the non-overlap region of the external metal layer in the first subpixel is less than a second width of the non-overlap region of the external metal layer in the second subpixel.

Example 20: The display apparatus of Example 19, wherein the plurality of subpixels further comprise a third subpixel configured to emit light of a color which differs from the lights of the colors emitted by the first and second subpixels, and a third width of a non-overlap region, which does not overlap the internal metal layer, of a region of the external metal layer overlapping the first active layer in the third subpixel differs from the first width and the second width.

Example 21: The display apparatus of Example 20, wherein the third subpixel is configured to emit red light, and the third width of the non-overlap region of the external metal layer in the third subpixel is greater than the first width and is less than the second width.

Example 22: The display apparatus of any of Examples 16 to 18, wherein, in each of the first and second subpixels, the internal metal layer is electrically connected to the gate electrode, and the external metal layer is electrically connected to one of the first and second source-drain regions, the first subpixel is configured to emit green light, and the second subpixel is configured to emit blue light, and a fourth width of the non-overlap region of the external metal layer in the first subpixel is greater than a fifth width of the non-overlap region of the external metal layer in the second subpixel.

Example 23: The display apparatus of Example 22, wherein the plurality of subpixels further comprise a third subpixel configured to emit light of a color which differs from the lights of the colors emitted by the first and second subpixels, and a sixth width of the non-overlap region of the external metal layer in the third subpixel differs from the fourth width and the fifth width.

Example 24: The display apparatus of Example 23, wherein the third subpixel is configured to emit red light, and the sixth width of the non-overlap region of the external metal layer in the third subpixel is greater than the fifth width and is less than the fourth width.

Example 25: A display apparatus comprising: a substrate; a driving transistor disposed in each of a plurality of subpixels disposed in an active area of the substrate, the driving transistor including a channel region, a first active layer including a first source-drain region and a second source-drain region at sides of the channel region, and a first gate electrode overlapping the first active layer; an external metal layer disposed between the first active layer and the substrate to overlap the first active layer; an internal metal layer disposed between the first active layer and the external metal layer to overlap the first active layer and the external metal layer; and a switching transistor disposed in each of the plurality of subpixels disposed in the active area of the substrate, the switching transistor including a second active layer, a second gate electrode overlapping the second active layer, and a lower metal layer disposed on a same layer as one of the internal metal layer and the external metal layer.

Example 26: A display panel comprising: a transistor disposed in each of a plurality of subpixels disposed in an active area of a substrate, the transistor including a channel region, an active layer, and a gate electrode overlapping the active layer; an external metal layer disposed between the active layer and the substrate to overlap the active layer; and an internal metal layer disposed between the active layer and the external metal layer to overlap the active layer and the external metal layer, wherein the plurality of subpixels comprise a first subpixel and a second subpixel configured to emit lights of different colors, and wherein a width of a non-overlap region, which does not overlap the internal metal layer, of a region of the external metal layer overlapping the active layer in the first subpixel differs from a width of a non-overlap region, which does not overlap the internal metal layer, of a region of the external metal layer overlapping the active layer in the second subpixel.

Example 27: A display panel comprising: a transistor disposed in each of a plurality of subpixels disposed in an active area of a substrate, the transistor including a channel region, a first active layer, and a first gate electrode overlapping the first active layer; an external metal layer disposed between the first active layer and the substrate to overlap the first active layer; an internal metal layer disposed between the first active layer and the external metal layer to overlap the first active layer and the external metal layer, wherein the plurality of subpixels comprise a first subpixel and a second subpixel configured to emit lights of different colors, and wherein a width of a non-overlap region, which does not overlap the internal metal layer, of a region of the external metal layer overlapping the first active layer in the first subpixel differs from a width of a non-overlap region, which does not overlap the internal metal layer, of a region of the external metal layer overlapping the first active layer in the second subpixel; and a switching transistor disposed in each of the plurality of subpixels disposed in the active area of the substrate, the switching transistor including a second active layer, a second gate electrode overlapping the second active layer, and a lower metal layer disposed on a same layer as one of the internal metal layer and the external metal layer.

Example 28: A display panel comprising: a driving transistor disposed in each of a plurality of subpixels disposed in an active area of s substrate, the driving transistor including a channel region, a first active layer including first and second source-drain regions at both sides of the channel region, and a first gate electrode overlapping the first active layer; an external metal layer disposed between the first active layer and the substrate to overlap the first active layer; an internal metal layer disposed between the first active layer and the external metal layer to overlap the first active layer and the external metal layer; and a switching transistor disposed in each of the plurality of subpixels disposed in the active area of the substrate, the switching transistor including a second active layer, a second gate electrode overlapping the second active layer, and a lower metal layer disposed on a same layer as one of the internal metal layer and the external metal layer.

## Claims

1. A display apparatus comprising:
a substrate (100);
a transistor (TR2) disposed in each of a plurality of subpixels (SP) disposed in an active area (AA) of the substrate (100), the transistor (TR2) including a channel region (CH), an active layer (ACT) including a first source-drain region (ASDa) and a second source-drain region (ASDb) at sides of the channel region (CH), and a gate electrode (G) overlapping the active layer (ACT);
an external metal layer (LSb) disposed between the active layer (ACT) and the substrate (100) to overlap the active layer (ACT); and
an internal metal layer (LSa) disposed between the active layer (ACT) and the external metal layer (LSb) to overlap the active layer (ACT) and the external metal layer (LSb),
wherein the plurality of subpixels (SP) comprise a first subpixel (SP1) and a second subpixel (SP2) configured to emit lights of different colors, and
wherein a width (W1, W1') of a non-overlap region (NOA), which does not overlap the internal metal layer (LSa), of a region of the external metal layer (LSb) overlapping the active layer (ACT) in the first subpixel (SP1) differs from a width (W2, W2') of a non-overlap region (NOA), which does not overlap the internal metal layer (LSa), of a region of the external metal layer (LSb) overlapping the active layer (ACT) in the second subpixel (SP2).

2. The display apparatus of claim 1, wherein, in each of the first and second subpixels (SP1, SP2),
the entire channel region (CH) overlaps the external metal layer (LSb),
a width of the internal metal layer (LSa) is less than a width of the external metal layer (LSb), and
one end of the internal metal layer (LSa) disposed at an opposite side of the non-overlap region (NOA) of the external metal layer (LSb) is disposed at a portion overlapping one of the first and second source-drain regions (ASDa, ASDb).

3. The display apparatus of claim 1 or 2, wherein the transistor (TR2) is arranged to supply a driving current to a light emitting device (OLED, 600) in a corresponding subpixel (SP) of the plurality of subpixels (SP).

4. The display apparatus of any of claims 1 to 3, wherein, in each of the first and second subpixels (SP1, SP2),
the external metal layer (LSb) is electrically connected to one of the gate electrode (G) and one of the first and second source-drain regions (ASDa, ASDb), and
the internal metal layer (LSa) is electrically connected to the other of the gate electrode (G) and one of the first and second source-drain regions (ASDa, ASDb).

5. The display apparatus of claim 4, wherein, in each of the first and second subpixels (SP1, SP2),
the external metal layer (LSb) is electrically connected to the gate electrode (G), and
the internal metal layer (LSa) is electrically connected to one of the first and second source-drain regions (ASDa, ASDb).

6. The display apparatus of claim 4, wherein, in each of the first and second subpixels (SP1, SP2),
the external metal layer (LSb) is electrically connected to one of the first and second source-drain regions (ASDa, ASDb), and
the internal metal layer (LSa) is electrically connected to the gate electrode (G).

7. The display apparatus of any of claims 1 to 4, wherein, in each of the first and second subpixels (SP1, SP2),
the internal metal layer (LSa) is electrically connected to one of the first and second source-drain regions (ASDa, ASDb), and the external metal layer (LSb) is electrically connected to the gate electrode (G),
the first subpixel (SP1) is configured to emit green light, and the second subpixel (SP2) is configured to emit blue light, and
a first width (W1) of the non-overlap region (NOA) of the external metal layer (LSb) in the first subpixel (SP1) is less than a second width (W2) of the non-overlap region (NOA) of the external metal layer (LSb) in the second subpixel (SP2).

8. The display apparatus of claim 7, wherein an end of one side of the internal metal layer (LSa) in the first subpixel (SP1) overlaps the first source-drain region (ASDa), and an end of another side of the internal metal layer (LSa) adjacent to the non-overlap region (NOA) of the external metal layer (LSb) overlaps the second source-drain region (ASDb), and
an end of one side of the internal metal layer (LSa) in the second subpixel (SP2) overlaps the first source-drain region (ASDa), and an end of another side of the internal metal layer (LSa) adjacent to the non-overlap region (NOA) of the external metal layer (LSb) overlaps the channel region (CH).

9. The display apparatus of claim 7 or 8, wherein the plurality of subpixels (SP) further comprise a third subpixel (SP3) configured to emit light of a color which differs from the first and second subpixels (SP1, SP2), and
a third width (W3) of a non-overlap region (NOA), which does not overlap the internal metal layer (LSa), of a region of the external metal layer (LSb) overlapping the active layer (ACT) in the third subpixel (SP3) differs from the first width (W1) and the second width (W2).

10. The display apparatus of claim 9, wherein the third subpixel (SP3) is configured to emit red light, and
the third width (W3) of the non-overlap region (NOA) of the external metal layer (LSb) in the third subpixel (SP3) is greater than the first width (W1) and less than the second width (W2).

11. The display apparatus of any of claims 1 to 4, wherein, in each of the first and second subpixels (SP1, SP2), the internal metal layer (LSa) is electrically connected to the gate electrode (G), and the external metal layer (LSb) is electrically connected to one of the first and second source-drain regions (ASDa, ASDb),
the first subpixel (SP1) is configured to emit green light, and the second subpixel (SP2) is configured to emit blue light, and
a fourth width (W1') of the non-overlap region (NOA) of the external metal layer (LSb) in the first subpixel (SP1) is greater than a fifth width (W2') of the non-overlap region (NOA) of the external metal layer (LSb) in the second subpixel (SP2).

12. The display apparatus of claim 11, wherein an end of one side of the internal metal layer (LSa) in the first subpixel (SP1) overlaps the first source-drain region (ASDa), and an end of another side of the internal metal layer (LSa) adjacent to the non-overlap region (NOA) of the external metal layer (LSb) overlaps the channel region (CH), and
an end of one side of the internal metal layer (LSa) in the second subpixel (SP2) overlaps the first source-drain region (ASDa), and an end of another side of the internal metal layer (LSa) adjacent to the non-overlap region (NOA) of the external metal layer (LSb) overlaps the second source-drain region (ASDb).

13. The display apparatus of claim 11 or 12, wherein the plurality of subpixels (SP) further comprise a third subpixel (SP3) configured to emit light of a color which differs from the lights of the colors emitted by the first and second subpixels (SP1, SP2), and
a sixth width (W3') of the non-overlap region (NOA) of the external metal layer (LSb) in the third subpixel (SP3) differs from the fourth width (W1') and the fifth width (W2').

14. The display apparatus of claim 13, wherein the third subpixel (SP3) is configured to emit red light, and
the sixth width (W3') of the non-overlap region (NOA) of the external metal layer (LSb) in the third subpixel (SP3) is greater than the fifth width (W2') and is less than the fourth width (W1').

15. The display apparatus of any of claims 1 to 14, wherein the active layer (ACT) comprises an oxide semiconductor material.
